# EUROPEAN PATENT APPLICATION

(11) **EP 4 629 804 A1**
(43) Date of publication of application: **08.10.2025**
(21) Application number: 25167573.2
(22) Date of filing: 31.03.2025
(51) Int. Cl.: H10K 59/131, H10K 59/35

(54) **DISPLAY DEVICE AND ELECTRONIC DEVICE**

(30) Priority: 02.04.2024 KR 20240044791
(71) Applicant: Samsung Display Co., Ltd., Yongin-si, Gyeonggi-do 17113 (KR)
(72) Inventor: CHO, Youngjin, 17113 Yongin-si (KR); NOH, Jaedu, 17113 Yongin-si (KR); LEE, Changyeol, 17113 Yongin-si (KR); JANG, Soyoung, 17113 Yongin-si (KR); JO, Eunbyul, 17113 Yongin-si (KR)
(74) Representative: Walaski, Jan Filip

(57) **Abstract**

A display device includes first to fourth pixels (Pa, Pb, Pc, Pd), wherein each of the first to fourth pixels includes first to third sub-pixels (SP1, SP2, SP3), a first data connection pattern (DCP1a) electrically connected to a first data line (DL1) by a first contact hole (CNT1a) and electrically connected to the second sub-pixel of the second pixel, and a second data connection pattern (DCP2a) electrically connected to a second data line (DL2) by a second contact hole (CNT1b) and electrically connected to the second sub-pixel of the fourth pixel, wherein, in a plan view, the first contact hole is disposed between the emission area of the third sub-pixel of the first pixel and the emission area of the third sub-pixel of the second pixel, and in a plan view, the first contact hole and the second contact hole are disposed in a row in the second direction.

## Description

### CROSS-REFERENCE TO RELATED APPLICATION(S)

This application claims priority to Korean Patent Application No. 10-2024-0044791 filed on 2 April 2024, in the Korean Intellectual Property Office.

### BACKGROUND

### 1. Technical Field

The disclosure relates to a display device.

### 2. Description of the Related Art

Recently, the purposes of display devices have diversified. Also, with the expansion of the range of use of display devices, the demand for high-resolution display devices has increased. To manufacture high-resolution display devices, it is required to arrange electronic components of various configurations in a narrow area.

### SUMMARY

One or more embodiments include a structure of a display device in which color deviation according to a viewing angle is reduced.

However, embodiments are not limited to those set forth herein. The above and other embodiments will become more apparent to one of ordinary skill in the art to which the disclosure pertains by referencing the detailed description of the disclosure given below.

According to one or more embodiments, a display device includes pixels including a first pixel, a second pixel adjacent to the first pixel in a first direction, a third pixel adjacent to the first pixel in a second direction perpendicular to the first direction, and a fourth pixel adjacent to the third pixel in the first direction and adjacent to the second pixel in the second direction, wherein each of the first pixel, the second pixel, the third pixel, and the fourth pixel includes a first sub-pixel, a second sub-pixel, and a third sub-pixel, which emit light of different colors, a first data line extending in the first direction and transmitting a data voltage to the second sub-pixel of the first pixel and the second sub-pixel of the second pixel, a second data line extending in the first direction and transmitting a data voltage to the second sub-pixel of the third pixel and the second sub-pixel of the fourth pixel, a first data connection pattern electrically connected to the first data line by a first contact hole and electrically connected to the second sub-pixel of the second pixel, and a second data connection pattern electrically connected to the second data line by a second contact hole and electrically connected to the second sub-pixel of the fourth pixel, wherein a distance between an emission area of the third sub-pixel of the first pixel and an emission area of the third sub-pixel of the second pixel is less than a distance between an emission area of the third sub-pixel of the third pixel and an emission area of the third sub-pixel of the fourth pixel in a plan view, the first contact hole is disposed between the emission area of the third sub-pixel of the first pixel and the emission area of the third sub-pixel of the second pixel in a plan view, and the first contact hole and the second contact hole are disposed in a row in the second direction in a plan view.

In a plan view, the first contact hole may be spaced apart from the emission area of the third sub-pixel of the first pixel and the emission area of the third sub-pixel of the second pixel.

In a plan view, the second contact hole may be disposed between the emission area of the third sub-pixel of the third pixel and the emission area of the third sub-pixel of the fourth pixel.

The display device may further include a third data line extending in the first direction and transmitting a data voltage to the first sub-pixel of the first pixel and the first sub-pixel of the second pixel, and a third data connection pattern electrically connected to the third data line by a third contact hole and electrically connected to the first sub-pixel of the second pixel, wherein, in a plan view, the first contact hole, the second contact hole, and the third contact hole may be disposed in a row in the second direction.

The display device may further include a fourth data line extending in the first direction and transmitting a data voltage to the third sub-pixel of the first pixel and the third sub-pixel of the second pixel, and a fourth data connection pattern electrically connected to the fourth data line by a fourth contact hole and electrically connected to the third sub-pixel of the second pixel, wherein, in a plan view, the first contact hole, the second contact hole, the third contact hole, and the fourth contact hole may be disposed in a row in the second direction.

The display device may further include a first vertical voltage line extending in the first direction and transmitting a first voltage that is a constant voltage to each of the first pixel, the second pixel, the third pixel, and the fourth pixel, and a first voltage connection pattern electrically connected to the first vertical voltage line by a fifth contact hole, wherein, in a plan view, the first contact hole, the second contact hole, and the fifth contact hole may be disposed in a row in the second direction.

The display device may further include a second vertical voltage line extending in the first direction and transmitting a second voltage that is a constant voltage to each of the first pixel, the second pixel, the third pixel, and the fourth pixel, and a second voltage connection pattern electrically connected to the second vertical voltage line by a sixth contact hole, wherein, in a plan view, the first contact hole, the second contact hole, the fifth contact hole, and the sixth contact hole may be disposed in a row in the second direction.

In a plan view, the fifth contact hole may be disposed between the emission area of the third sub-pixel of the first pixel and the emission area of the third sub-pixel of the second pixel, and the sixth contact hole may be disposed between the emission area of the third sub-pixel of the third pixel and the emission area of the third sub-pixel of the fourth pixel.

The first data line, the second data line, the first vertical voltage line, and the second vertical voltage line may be disposed on the same layer.

The first data connection pattern, the second data connection pattern, the first voltage connection pattern, and the second voltage connection pattern may be disposed on the same layer.

The display device may further include a first horizontal voltage line extending in the second direction and electrically connected to the first voltage connection pattern.

The display device may further include a second horizontal voltage line disposed on a different layer from the first horizontal voltage line, extending in the second direction, and electrically connected to the second voltage connection pattern.

The display device may further include a plurality of separators, wherein, in a plan view, a separator from among the plurality of separators may surround the emission area of the third sub-pixel of the first pixel and the emission area of the third sub-pixel of the second pixel.

The third sub-pixel may emit blue light.

A size of the emission area of the third sub-pixel may be greater than a size of the emission area of the first sub-pixel and a size of the emission area of the second sub-pixel.

According to one or more embodiments, a display device includes a plurality of pixels each including a first sub-pixel, a second sub-pixel, and a third sub-pixel, which emit light of different colors, a data line extending in a first direction and transmitting a data voltage to at least one pixel from among the plurality of pixels, a first vertical voltage line extending in the first direction and transmitting a first voltage that is a constant voltage to the plurality of pixels, a data connection pattern electrically connected to the data line by a first contact hole, and a first voltage connection pattern electrically connected to the first vertical voltage line by a second contact hole, wherein, in a plan view, the first contact hole and the second contact hole are disposed in a row in a second direction perpendicular to the first direction.

The plurality of pixels may include a first pixel, a second pixel adjacent to the first pixel in the first direction, a third pixel adjacent to the first pixel in the second direction perpendicular to the first direction, and a fourth pixel adjacent to the third pixel in the first direction and adjacent to the second pixel in the second direction, wherein, in a plan view, a distance between an emission area of the third sub-pixel of the first pixel and an emission area of the third sub-pixel of the second pixel may be less than a distance between an emission area of the third sub-pixel of the third pixel and an emission area of the third sub-pixel of the fourth pixel, and in a plan view, the second contact hole may be disposed between the emission area of the third sub-pixel of the first pixel and the emission area of the third sub-pixel of the second pixel.

The display device may further include a second vertical voltage line extending in the first direction and transmitting a second voltage that is a constant voltage to the plurality of pixels, and a second voltage connection pattern electrically connected to the second vertical voltage line by a third contact hole, wherein, in a plan view, the third contact hole may be disposed in a row with the first contact hole and the second contact hole in the second direction.

In a plan view, the third contact hole may be disposed between the emission area of the third sub-pixel of the third pixel and the emission area of the third sub-pixel of the fourth pixel.

The display device may further include a first horizontal voltage line extending in the second direction and electrically connected to the first voltage connection pattern.

The display device may further include a second horizontal voltage line disposed on a different layer from the first horizontal voltage line, extending in the second direction, and electrically connected to the second voltage connection pattern.

The third sub-pixel may emit blue light.

According to one or more embodiments, a display device includes a substrate including a display area and a peripheral area disposed outside the display area, a plurality of pixels disposed in the display area and each including a first sub-pixel, a second sub-pixel, and a third sub-pixel, which emit light of different colors, a first semiconductor layer disposed on the substrate and including a silicon semiconductor, a first conductive layer disposed on the first semiconductor layer, a second conductive layer disposed on the first conductive layer, a second semiconductor layer disposed on the second conductive layer and including an oxide semiconductor, a third conductive layer disposed on the second semiconductor layer, a fourth conductive layer disposed on the third conductive layer and including a plurality of connection conductive patterns, a fifth conductive layer disposed on the fourth conductive layer, the fifth conductive layer including a plurality of vertical conductive lines electrically connected to the plurality of connection conductive patterns respectively, and each extending in a first direction, and a via insulating layer disposed between the fourth conductive layer and the fifth conductive layer, the via insulating layer defining a plurality of contact holes electrically respectively connecting the plurality of connection conductive patterns to the plurality of vertical conductive lines, wherein, in a plan view, the plurality of contact holes of the via insulating layer are spaced apart from emission areas of the first sub-pixel, the second sub-pixel, and the third sub-pixel.

The plurality of pixels may include a first pixel, a second pixel adjacent to the first pixel in a first direction, a third pixel adjacent to the first pixel in a second direction perpendicular to the first direction, and a fourth pixel adjacent to the third pixel in the first direction and adjacent to the second pixel in the second direction, in a plan view, a distance between an emission area of the third sub-pixel of the first pixel and an emission area of the third sub-pixel of the second pixel may be less than a distance between an emission area of the third sub-pixel of the third pixel and an emission area of the third sub-pixel of the fourth pixel, and in a plan view, a first contact hole from among the plurality of contact holes may be disposed between the emission area of the third sub-pixel of the first pixel and the emission area of the third sub-pixel of the second pixel.

In a plan view, a second contact hole from among the plurality of contact holes may be disposed between the emission area of the third sub-pixel of the first pixel and the emission area of the third sub-pixel of the second pixel.

The first contact hole and the second contact hole may be disposed in a row in the second direction.

According to an embodiment, an electronic device includes pixels including a first pixel, a second pixel adjacent to the first pixel in a first direction, a third pixel adjacent to the first pixel in a second direction perpendicular to the first direction, and a fourth pixel adjacent to the third pixel in the first direction and adjacent to the second pixel in the second direction, wherein each of the first pixel, the second pixel, the third pixel, and the fourth pixel includes a first sub-pixel, a second sub-pixel, and a third sub-pixel, which emit light of different colors, a first data line extending in the first direction and transmitting a data voltage to the second sub-pixel of the first pixel and the second sub-pixel of the second pixel, a second data line extending in the first direction and transmitting a data voltage to the second sub-pixel of the third pixel and the second sub-pixel of the fourth pixel, a first data connection pattern electrically connected to the first data line by a first contact hole and electrically connected to the second sub-pixel of the second pixel, and a second data connection pattern electrically connected to the second data line by a second contact hole and electrically connected to the second sub-pixel of the fourth pixel, wherein a distance between an emission area of the third sub-pixel of the first pixel and an emission area of the third sub-pixel of the second pixel is less than a distance between an emission area of the third sub-pixel of the third pixel and an emission area of the third sub-pixel of the fourth pixel in a plan view, the first contact hole is disposed between the emission area of the third sub-pixel of the first pixel and the emission area of the third sub-pixel of the second pixel in a plan view, and the first contact hole and the second contact hole are disposed in a row in the second direction in a plan view.

### BRIEF DESCRIPTION OF THE DRAWINGS

The above and other aspects, features, and advantages of certain embodiments will be more apparent from the following description taken in conjunction with the accompanying drawings, in which:
FIG. 1 is a schematic plan view showing a display device;
FIG. 2 is a block diagram showing a display device;
FIG. 3 is a schematic diagram of an equivalent circuit of a light-emitting diode and a pixel circuit arranged in a display device;
FIG. 4 is a schematic cross-sectional view of a portion of a display area of a display device;
FIG. 5 is a schematic plan view showing a portion of wires arranged in a display area of a display device;
FIG. 6 is a schematic plan view showing arrangements of wires and emission areas of a plurality of pixels, which are arranged in a display area of a display device;
FIG. 7 is an enlarged schematic view of a partial area of FIG. 6;
FIG. 8 is a plan view showing an excerpt of a first pixel circuit, a second pixel circuit, and a third pixel circuit of a display device;
FIGS. 9 to 18 are schematic plan views according to processes of forming the first pixel circuit, the second pixel circuit, and the third pixel circuit of FIG. 8;
FIG. 19 is a schematic cross-sectional view of the display device taken along line I-I' of FIG. 18;
FIGS. 20A and 20B are schematic cross-sectional views of the display device taken along line II-II' of FIG. 18; and
FIG. 21 is a schematic plan view showing electrical connections of four adjacent pixels.

### DETAILED DESCRIPTION OF THE EMBODIMENTS

In the following description, for the purposes of explanation, numerous specific details are set forth in order to provide a thorough understanding of various embodiments or implementations of the invention. As used herein, "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element or a layer is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the x-axis, the y-axis, and the z-axis DR3 are not limited to three axes of a rectangular coordinate system, and may be interpreted in a broader sense. For example, the x-axis, the yaxis, and the z-axis may be perpendicular to one another, or may represent different directions that are not perpendicular to one another. For the purposes of this disclosure, "at least one of A and B" may be understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

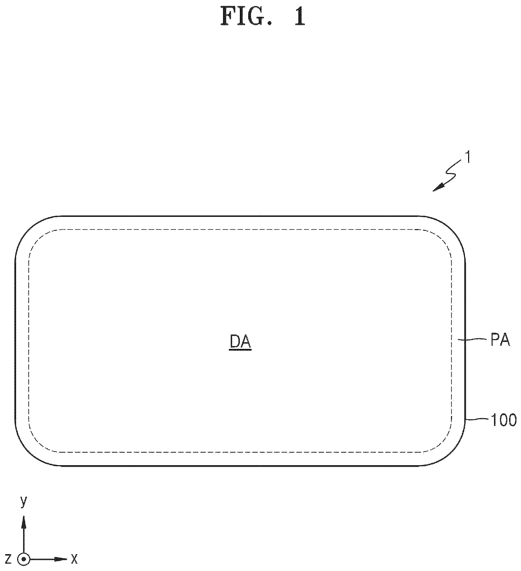

FIG. 1 is a schematic plan view showing a display device 1.

Referring to FIG. 1, the display device 1 may include a display area DA, where an image is displayed, and a peripheral area PA outside the display area DA. The display device 1 may provide a certain image by using light emitted from pixels arranged in the display area DA. The display device 1 may include a substrate 100, and thus, it may be understood that the substrate 100 includes the display area DA and the peripheral area PA.

In a plan view, the display area DA may have a rectangular shape. The display area DA may have another polygonal shape or may have a circular shape, an oval shape, or an atypical shape. The display area DA may have a round shape at a corner of an edge. The display device 1 may include the display area DA in which a length in a first direction (e.g., a y-axis direction) is less than a length in a second direction (e.g., an x-axis direction), as shown in FIG. 1. Alternatively, the display device 1 may include the display area DA in which the length in the first direction (e.g., a y-axis direction) is greater than the length in the second direction (e.g., an x-axis direction).

The peripheral area PA may be an area arranged around the display area DA and may surround at least a portion of the display area DA. The peripheral area PA may be a type of non-display area where pixels are not arranged. Various wires and circuits, each transmitting an electric signal to be applied to the pixels in the display area DA, and pads to which a printed circuit board or a driver integrated circuit (IC) chip is attached may be located in the peripheral area PA.

An electronic device may include the display device 1. For example, the display device 1 may be a device for displaying a moving image or a still image, and may be used for a portable electronic device, such as a mobile phone, a laptop computer, a tablet personal computer (PC), a smartphone, a mobile communication terminal, an electronic notebook, an electronic book, a portable multimedia player (PMP), a navigation device, or an ultra mobile PC (UMPC). In another example, the display device 1 may be used for an electronic device for a television, a monitor, a billboard, or an electronic device for Internet of things (IoT) or may be used for a wearable electronic device, such as a smart watch, a watch phone, a glasses type display, or a head-mounted display (HMD). For example, the display device 1 may be used as a panel of a vehicle, a center information display (CID) arranged on a center fascia or dashboard of a vehicle, a room mirror display replacing a side mirror of a vehicle, or an electronic device for a display arranged on a rear surface of a front seat, as entertainment for a back seat of a vehicle. The electronic device including the display device 1 of FIG. 1 may include a lower cover disposed below the display device 1 and a cover window disposed on the display device 1. The lower cover of the electronic device and the cover window may be combined and form an exterior appearance of the electronic device.

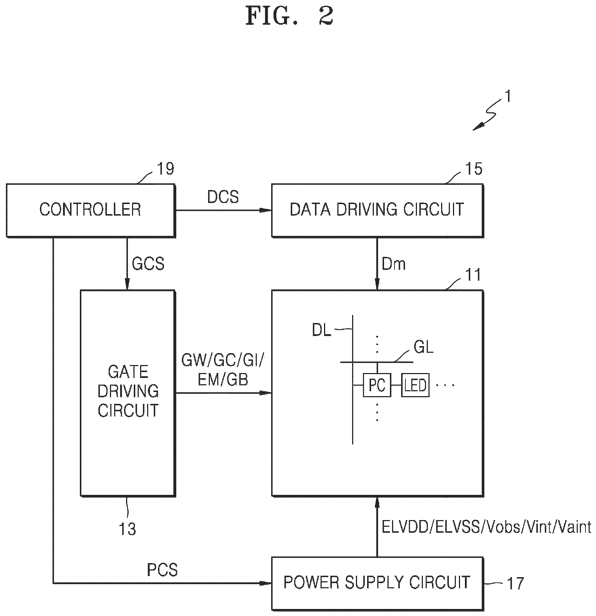

FIG. 2 is a block diagram showing the display device 1.

Referring to FIGS. 1 and 2, the display device 1 may include a pixel unit 11, a gate driving circuit 13, a data driving circuit 15, a power supply circuit 17, and a controller 19.

The pixel unit 11 may include the pixels arranged in the display area DA of FIG. 1. The pixels may include sub-pixels emitting light of different colors. The sub-pixels may be, for example, one of a red sub-pixel, a green sub-pixel, and a blue sub-pixel. The sub-pixels may realize an image by being arranged in various forms, such as a stripe arrangement, a pentile arrangement (e.g., diamond arrangement) and a mosaic arrangement. Each sub-pixel may include a light-emitting diode LED emitting light. The light-emitting diode LED of each of the sub-pixels may be electrically connected to a pixel circuit PC. Each pixel circuit PC may be electrically connected to a gate line GL and a data line DL, and may include transistors and at least one capacitor.

Various conductive lines that transmit an electric signal to be applied to the display area DA of FIG. 1, outer circuits electrically connected to pixel circuits, and pads to which a printed circuit board or a driver IC chip is attached may be located in the peripheral area PA of FIG. 1. For example, the gate driving circuit 13, the data driving circuit 15, the power supply circuit 17, and the controller 19 may be provided in the peripheral area PA of FIG. 1.

The gate driving circuit 13 may be electrically connected to the gate lines GL, and generate a gate signal in response to a control signal GCS from the controller 19, and sequentially supply the gate signal to the gate lines GL. The gate signal may be a gate control signal for controlling on and off of the transistor electrically connected to the gate line GL. The gate signal may be a square wave signal including an on voltage for turning the transistor on, and an off voltage for turning the transistor off. The on voltage may be a high-level voltage (e.g., first level voltage) or a low-level voltage (e.g., second level voltage).

In FIG. 2, one pixel circuit PC may be connected to one gate line GL, but this is only an example, and the pixel circuit PC may be connected to two or more gate lines GL and the gate driving circuit 13 may supply, to corresponding gate lines GL, two or more gate signals having different timings of applying an on voltage. For example, the pixel circuit PC may be electrically connected to the gate lines GL, and the gate driving circuit 13 may apply, to the pixel circuit PC through respective gate lines GL, a scan signal GW, a first initialization control signal GI, a second initialization control signal GB, a compensation scan signal GC, and an emission control signal EM.

The data driving circuit 15 may be connected to the data lines DL and supply a data signal Dm to the data lines DL, in response to a control signal DCS from the controller 19. The data signal Dm supplied to the data line DL may be provided to the pixel circuit PC. The data driving circuit 15 may convert input image data having a grayscale input from the controller 19 into the data signal Dm in the form of a voltage or current.

The power supply circuit 17 may generate voltages required to drive the pixel circuit PC and light-emitting diode LED, in response to a control signal PCS from the controller 19. The power supply circuit 17 may generate a driving voltage ELVDD and a common voltage ELVSS and supply the driving voltage ELVDD and the common voltage ELVSS to each of the pixel circuit PC and the light-emitting diode LED. The driving voltage ELVDD may be a high-level voltage provided to a first electrode (or a pixel electrode or an anode) of the light-emitting diode LED. The common voltage ELVSS may be a low-level voltage provided to a second electrode (or an opposing electrode or a cathode) of the light-emitting diode LED. The power supply circuit 17 may generate a bias voltage Vobs, a first initialization voltage Vint, and a second initialization voltage Vaint and supply them to the pixel circuit PC.

A voltage level of the driving voltage ELVDD may be greater than a voltage level of the common voltage ELVSS. Voltage levels of the first initialization voltage Vint and the second initialization voltage Vaint may be greater than the voltage level of the common voltage ELVSS. A voltage level of the bias voltage Vobs may be greater than the voltage level of the driving voltage ELVDD.

The controller 19 may generate the control signals GCS, DCS, and PCS, based on signals input from an external source, and supply them to the gate driving circuit 13, data driving circuit 15, and power supply circuit 17. The control signal GCS output to the gate driving circuit 13 may include clock signals and a gate initiation signal. The control signal DCS, output to the data driving circuit 15, may include a source initiation signal and clock signals.

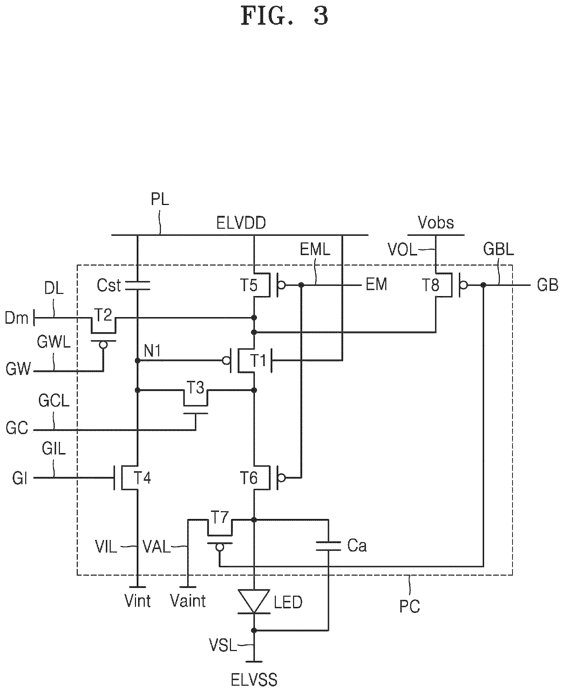

FIG. 3 is a schematic diagram of an equivalent circuit of a light-emitting diode LED and the pixel circuit PC arranged in the display device 1.

Referring to FIG. 3, the pixel circuit PC may be connected to each of gate lines GL, for example, a scan line GWL, a first initialization control line GIL, a second initialization control line GBL, a compensation scan line GCL, and an emission control line EML, and receive the scan signal GW, the first initialization control signal GI, the second initialization control signal GB, the compensation scan signal GC, and the emission control signal EM. For example, the scan line GWL, the first initialization control line GIL, the second initialization control line GBL, the compensation scan line GCL, and the emission control line EML of FIG. 3 may be gate lines GL connected to the pixel circuit PC located in an i-th row, wherein i may be a natural number.

The pixel circuit PC may receive the data signal Dm through the data line DL. For example, the data line DL of FIG. 3 may be a signal line connected to the pixel circuit PC located in a j-th column, wherein j may be a natural number.

The pixel circuit PC of the display device 1 may be electrically connected to the light-emitting diode LED emitting light of a certain color, and the light-emitting diode LED may include the first electrode (e.g., pixel electrode or anode), the second electrode (e.g., opposing electrode or cathode), and an intermediate layer therebetween.

The pixel circuit PC may include transistors T1, T2, T3, T4, T5, T6, T7, and T8, and capacitors Cst and Ca. The transistors T1, T2, T3, T4, T5, T6, T7, and T8 may include a driving transistor T1, a data write transistor T2, a compensation transistor T3, a first initialization transistor T4, an operation control transistor T5, an emission control transistor T6, a second initialization transistor T7, and a bias transistor T8. The capacitors Cst and Ca may include a first capacitor Cst and a second capacitor Ca.

Some of the transistors T1, T2, T3, T4, T5, T6, T7, and T8 may be p-channel metal oxide semiconductor field-effect transistors (p-channel MOSFETs) (PMOS) and the remaining ones may be n-channel metal oxide semiconductor field-effect transistors (n-channel MOSFETs) (NMOS). For example, among the transistors T1, T2, T3, T4, T5, T6, T7, and T8, the driving transistor T1, the data write transistor T2, the operation control transistor T5, the emission control transistor T6, the second initialization transistor T7, and the bias transistor T8 may be PMOS, and the compensation transistor T3 and the first initialization transistor T4 may be NMOS. In another example, among the transistors T1, T2, T3, T4, T5, T6, T7, and T8, the compensation transistor T3 and the first initialization transistor T4 may be PMOS and the remaining ones may be NMOS. In another example, all of the transistors T1, T2, T3, T4, T5, T6, T7, and T8 may be NMOS or PMOS. Hereinafter, an example in which the compensation transistor T3 and first initialization transistor T4 are NMOS including an oxide semiconductor, and the remaining are PMOS will be described.

At least one of the transistors T1, T2, T3, T4, T5, T6, T7, and T8 may be a transistor including a low-temperature polycrystalline silicon (LTPS) semiconductor layer, and at least one of the transistors T1, T2, T3, T4, T5, T6, T7, and T8 may be a transistor including an oxide semiconductor layer.

The driving transistor T1 that directly affects brightness of the display device 1 may include a semiconductor layer including polycrystalline silicon having high reliability so that the display device 1 having high resolution may be implemented. Because an oxide semiconductor has high carrier mobility and a low leakage current, a voltage drop may not be large although a driving time is long. For example, a color change of an image caused by the voltage drop may not be large during low-frequency driving, and thus, the low-frequency driving may be possible. For example, because the oxide semiconductor has a low leakage current, at least one of the compensation transistor T3 and the first initialization transistor T4 connected to a driving gate electrode of the driving transistor T1 may include the oxide semiconductor so as to prevent a leakage current that flows to the driving gate electrode while reducing power consumption. For example, the driving transistor T1, the data write transistor T2, the operation control transistor T5, the emission control transistor T6, the second initialization transistor T7, and the bias transistor T8 may be transistors including an LTPS semiconductor layer, and the compensation transistor T3 and the first initialization transistor T4 may be transistors including an oxide semiconductor layer.

The driving transistor T1 may be connected between the light-emitting diode LED and a driving voltage line PL (or a vertical driving voltage line) that provides the driving voltage ELVDD. A gate electrode of the driving transistor T1 may be connected to an end portion of the first capacitor Cst that is a storage capacitor. The gate electrode of the driving transistor T1 may be connected to a first node N1. A source electrode of the driving transistor T1 may be connected to the driving voltage line PL via the operation control transistor T5. A drain electrode of the driving transistor T1 may be electrically connected to the first electrode (or the pixel electrode or the anode) of the light-emitting diode LED via the emission control transistor T6. The driving transistor T1 may receive the data signal Dm transmitted from the data line DL and supply a driving current to the light-emitting diode LED, according to a switching operation of the data write transistor T2.

A gate electrode of the data write transistor T2 may be connected to the scan line GWL. A first electrode of the data write transistor T2 may be connected to the data line DL and a second electrode of the data write transistor T2 may be connected to the source electrode of the driving transistor T1. The data write transistor T2 may be turned on according to the scan signal GW received through the scan line GWL and transmit the data signal Dm received through the data line DL to the source electrode of the driving transistor T1, and the data signal Dm may be transmitted to the gate electrode of the driving transistor T1 by the compensation transistor T3 that is simultaneously turned on.

A gate electrode of the compensation transistor T3 may be connected to the compensation scan line GCL. A first electrode of the compensation transistor T3 may be connected to the drain electrode of the driving transistor T1 and a second electrode of the compensation transistor T3 may be connected to the first node N1. The compensation transistor T3 may be turned on according to compensation scan signal GC received through the compensation scan line GCL and compensate for a threshold voltage Vth of the driving transistor T1 by connecting the gate electrode to the drain electrode of the driving transistor T1 for diode-connection of the driving transistor T1.

A gate electrode of the first initialization transistor T4 may be connected to the first initialization control line GIL. A first electrode of the first initialization transistor T4 may be connected to a first initialization voltage line VIL and a second electrode of the first initialization transistor T4 may be connected to the first node N1. The first initialization transistor T4 may be turned on according to the first initialization control signal GI applied from the first initialization control line GIL and initialize a potential of the gate electrode of the driving transistor T1 (e.g., a potential of the first node N1) to a specific voltage by transmitting the first initialization voltage Vint to the gate electrode of the driving transistor T1. The first initialization voltage Vint may have a voltage level higher than or same as the common voltage ELVSS.

A gate electrode of the operation control transistor T5 may be connected to the emission control line EML. A first electrode of the operation control transistor T5 may be connected to the driving voltage line PL and a second electrode of the operation control transistor T5 may be connected to the source electrode of the driving transistor T1.

A gate electrode of the emission control transistor T6 may be connected to the emission control line EML. A first electrode of the emission control transistor T6 may be connected to the drain electrode of the driving transistor T1, and a second electrode of the emission control transistor T6 may be electrically connected to the first electrode (or the pixel electrode or the anode) of the light-emitting diode LED. The operation control transistor T5 and the emission control transistor T6 may be simultaneously turned on according to the emission control signal EM applied from the emission control line EML. The driving voltage ELVDD applied through the turned-on operation control transistor T5 may be transmitted to the light-emitting diode LED after being compensated for through the driving transistor T1.

A gate electrode of the second initialization transistor T7 may be connected to the second initialization control line GBL. A first electrode of the second initialization transistor T7 may be connected to the first electrode (or the pixel electrode or the anode) of the light-emitting diode LED, and a second electrode of the second initialization transistor T7 may be connected to a second initialization voltage line VAL. The second initialization transistor T7 may be turned on by the second initialization control signal GB applied from the second initialization control line GBL and initialize the first electrode (or the pixel electrode or the anode) of the light-emitting diode LED. The second initialization control signal GB may be the same signal as, or a different signal from, the first initialization control signal GI.

According to a comparative example, in the case that the light-emitting diode LED emits light and a minimum current of the driving transistor T1 displaying a black image flows as the driving current, the black image may not be properly displayed. However, the second initialization transistor T7 may distribute, as a bypass current, a part of the minimum current of the driving transistor T1 to a current path other than a current path towards the light-emitting diode LED. For example, the minimum current of the driving transistor T1 may denote a current under a condition where the driving transistor T1 is turned off because a gate-source voltage Vgs of the driving transistor T1 is smaller than the threshold voltage Vth. For example, a minimum driving current (e.g., a current of 10 picoampere (pA) or lower) under a condition where the driving transistor T1 is turned off is transmitted to the light-emitting diode LED, and thus, an image of black luminance may be displayed. In the case that the minimum driving current for displaying the black image flows, an effect of bypass transmission of the bypass current may be large, but in case that a large driving current for displaying an image such as a general image or white image flows, an effect of the bypass current may be almost negligible. Accordingly, in case that a driving current for displaying a black image flows, a contrast ratio may be improved by realizing an accurate black luminance image by using the second initialization transistor T7 from the driving current. Thus, the display device 1 with improved display quality may be provided.

A gate electrode of the bias transistor T8 may be connected to the second initialization control line GBL. A first electrode of the bias transistor T8 may be connected to a bias voltage line VOL that provides the bias voltage Vobs, and a second electrode of the bias transistor T8 may be connected to the source electrode of the driving transistor T1.

An end portion of the first capacitor Cst may be connected to the gate electrode of the driving transistor T1 and another end portion of the first capacitor Cst may be connected to the driving voltage line PL. The first capacitor Cst may be connected between the driving voltage line PL and the first node N1. The first capacitor Cst may store a voltage between the driving voltage ELVDD and the first node N1.

The second capacitor Ca may be an auxiliary capacitor and electrically connected to the emission control transistor T6, the second initialization transistor T7, and the first electrode (or the pixel electrode or the anode) of the light-emitting diode LED. The second capacitor Ca may store and may maintain a voltage corresponding to a voltage difference between the first electrode (or the pixel electrode or the anode) of the light-emitting diode LED and a common voltage line VSL in case that the second initialization transistor T7 is turned on, thereby preventing an increase in black luminance in case that the emission control transistor T6 is turned off.

The first electrode (or the pixel electrode or the anode) of the light-emitting diode LED may receive the driving current from the driving transistor T1 and emit light to display an image. The driving voltage ELVDD may be a certain high-level voltage and the common voltage ELVSS may be a voltage lower than the driving voltage ELVDD.

Hereinafter, operations of the pixel circuit PC and light-emitting diode LED will be described.

During an initialization period, the first initialization control signal GI of a high level may be supplied to the first initialization transistor T4 through the first initialization control line GIL, and the second initialization control signal GB of a low level may be supplied to the second initialization transistor T7 through the second initialization control line GBL. As a result, the first initialization transistor T4 and the second initialization transistor T7 may be turned on. The first initialization voltage Vint applied from the first initialization voltage line VIL may be transmitted to the gate electrode of the driving transistor T1 through the first initialization transistor T4, and the second initialization voltage Vaint applied from the second initialization voltage line VAL may be transmitted to the anode through the second initialization transistor T7. Accordingly, voltages of the anode and the gate electrode of the driving transistor T1 may be initialized.

Then, during a data write period, the scan signal GW of a low level may be supplied through the scan line GWL, the compensation scan signal GC of a high level may be supplied through the compensation scan line GCL, and the data write transistor T2 and the compensation transistor T3 may be turned on. The data write transistor T2 may transmit the data signal Dm from the data line DL to the source electrode of the driving transistor T1, and the driving transistor T1 may be diode-connected by the compensation transistor T3. Accordingly, a compensation voltage obtained by subtracting a threshold voltage of the driving transistor T1 from the data signal Dm may be applied to the gate electrode of the driving transistor T1.

The driving voltage ELVDD and the compensation voltage may be applied to end portions (e.g., opposite ends) of the first capacitor Cst, and charges corresponding to a difference between voltages at the end portions may be stored in the first capacitor Cst.

Then, during an emission period, the emission control signal EM supplied from the emission control line EML may be changed from a high level to a low level, and the operation control transistor T5 and the emission control transistor T6 may be turned on. Consequently, a driving current corresponding to a voltage difference between a voltage of the gate electrode of the driving transistor T1 and the driving voltage ELVDD may be generated, and the driving current may be supplied to the light-emitting diode LED through the emission control transistor T6, and thus, the light-emitting diode LED may emit light.

Characteristics of the light-emitting diodes LED emitting light of different colors and/or characteristics of the driving transistors T1 of the pixel circuits PC may be different. For example, color coordinates of the display device 1 may be changed (e.g., reddish) during a high-frequency operation. However, a voltage of the source electrode of the driving transistor T1 may be controlled through the bias voltage Vobs by using the bias transistor T8. For example, by controlling a driving current, sub-pixel luminance deviation (e.g., current deviation) and the change in the color coordinates may be improved. Thus, the display device 1 with improved display quality may be provided.

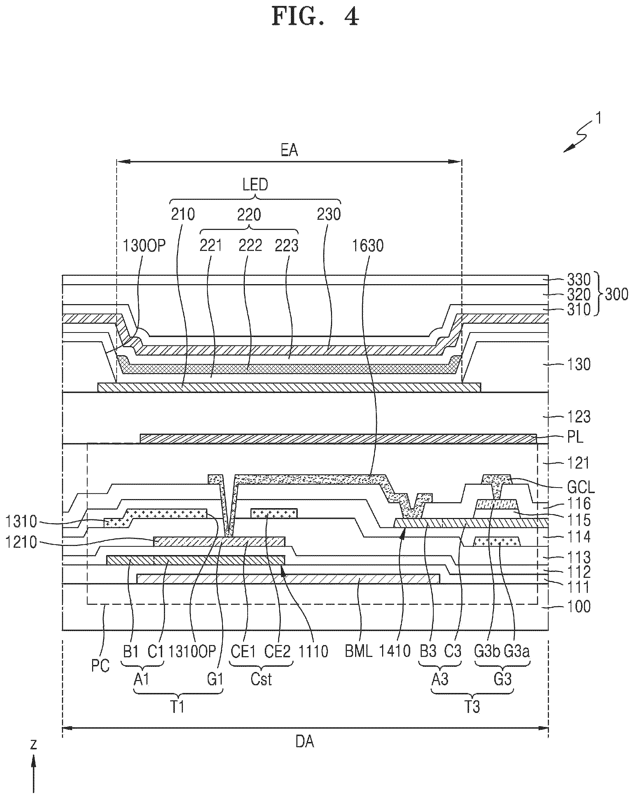

FIG. 4 is a schematic cross-sectional view of a portion of the display area DA of the display device 1.

Referring to FIG. 4, the pixel circuit PC may be disposed on the substrate 100 and the light-emitting diode LED may be disposed on the pixel circuit PC.

The substrate 100 may include glass, a metal, or a polymer resin. The substrate 100 may be flexible or bendable. In case that the substrate 100 is flexible or bendable, the substrate 100 may include a polymer resin, for example, polyethersulfone, polyarylate, polyetherimide, polyethylene naphthalate, polyethylene terephthalate, polyphenylene sulfide, polyarylate, polyimide, polycarbonate, or cellulose acetate propionate.

The substrate 100 may have a single layer structure or a multilayer structure of such a material, and may further include an inorganic layer in case of the multilayer structure. For example, the substrate 100 may include a first organic base layer, a first inorganic barrier layer, a second organic base layer, and a second inorganic barrier layer. The first organic base layer and the second organic base layer may each include a polymer resin. The first inorganic barrier layer and the second inorganic barrier layer may be barrier layers for preventing penetration of external impurities, and may be a single layer or a multilayer including an inorganic insulating material such as silicon nitride and/or silicon oxide.

A lower metal layer BML may be disposed on the substrate 100. The lower metal layer BML may include one or more materials selected from aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and copper (Cu). The lower metal layer BML may be a single Mo layer, may have a double layer structure in which a Mo layer and a Ti layer are stacked with each other, or may have a triple layer structure in which a Ti layer, an Al layer, and a Ti layer are stacked with each other.

The lower metal layer BML may have a voltage level of a constant voltage. For example, the lower metal layer BML may have the same voltage level (e.g., the driving voltage ELVDD of FIG. 3) as the driving voltage line PL by being electrically connected to the driving voltage line PL described with reference to FIG. 3. The lower metal layer BML prevents negative (-) charges from gathering below a semiconductor layer (hereinafter, a driving semiconductor layer A1) of the driving transistor T1, thereby preventing or reducing occurrence of an afterimage caused by the negative (-) charges. When viewed in a direction perpendicular to a top surface of the substrate 100, the lower metal layer BML may overlap (e.g., entirely overlap) a channel region C1 of the driving semiconductor layer A1 of the driving transistor T1.

A buffer layer 111 may be disposed on the lower metal layer BML. The buffer layer 111 may be an inorganic insulating layer including an inorganic insulating material, such as a silicon nitride and/or a silicon oxide, and may have a single layer structure or a multilayer structure including the above material.

Transistors including a silicon semiconductor layer may be disposed on the buffer layer 111. FIG. 4 illustrates the driving semiconductor layer A1 of the driving transistor T1, which corresponds to a portion of a first silicon semiconductor pattern 1110. The driving semiconductor layer A1 may include impurity-doped impurity regions arranged in the channel region C1 and on sides (e.g., opposite sides) of the channel region C1, and FIG. 4 illustrates a first region B1 that is one of impurity regions arranged on a side of the channel region C1.

A first gate insulating layer 112 may be disposed on the first silicon semiconductor pattern 1110, for example, the driving semiconductor layer A1. The first gate insulating layer 112 may be an inorganic insulating layer including an inorganic insulating material, such as silicon oxide, silicon nitride, or silicon oxynitride, and may include a single layer structure or a multilayer structure including the above material.

A first conductive pattern 1210 may be disposed on the first gate insulating layer 112. The first conductive pattern 1210 may include a driving gate electrode G1 and/or a lower electrode CE1 of the first capacitor Cst. The first conductive pattern 1210 may perform a function both the driving gate electrode G1 and the lower electrode CE1 of the first capacitor Cst or the lower electrode CE1 may perform a function of the driving gate electrode G1. For example, the driving gate electrode G1 may be integrated with the lower electrode CE1.

The first conductive pattern 1210, for example, the driving gate electrode G1 and/or the lower electrode CE1 of the first capacitor Cst, may include Al, Pt, Pd, Ag, Mg, Au, Ni, Nd, Ir, Cr, Li, Ca, Mo, Ti, W, and/or Cu, and may be formed in a single layer structure or a multilayer structure including the above material. The driving gate electrode G1 and/or the lower electrode CE1 of the first capacitor Cst may include a Mo single layer.

A second gate insulating layer 113 may be disposed on the driving gate electrode G1 and/or the lower electrode CE1 of the first capacitor Cst. The second gate insulating layer 113 may be an inorganic insulating layer including an inorganic insulating material, such as silicon oxide, silicon nitride, or silicon oxynitride, and may include a single layer structure or a multilayer structure including the above material.

Another conductive pattern (hereinafter, referred to as a third conductive pattern 1310) may be disposed on the second gate insulating layer 113. The third conductive pattern 1310 may include an upper electrode CE2 of the first capacitor Cst. The third conductive pattern 1310, for example, the upper electrode CE2 of the first capacitor Cst, may include Al, Pt, Pd, Ag, Mg, Au, Ni, Nd, Ir, Cr, Li, Ca, Mo, Ti, W, and/or Cu, and may be formed in a single layer or a multilayer including the above material. The upper electrode CE2, the lower electrode CE1, and/or the lower metal layer BML may include the same material.

The upper electrode CE2 may overlap the driving gate electrode G1 and/or the lower electrode CE1. The upper electrode CE2 may include an opening 1310OP for a first connection electrode 1630 to be connected to the driving gate electrode G1. For example, the first connection electrode 1630 may electrically connect the driving gate electrode G1 of the driving transistor T1 to a compensation semiconductor layer A3 of the compensation transistor T3. The opening 1310OP may overlap a portion of the driving gate electrode G1.

A first interlayer insulating layer 114 may be disposed on the upper electrode CE2. The first interlayer insulating layer 114 may be an inorganic insulating layer including an inorganic insulating material, such as silicon oxide, silicon nitride, or silicon oxynitride, and may include a single layer structure or a multilayer structure including the above material.

An oxide semiconductor pattern 1410 may be disposed on the first interlayer insulating layer 114. FIG. 4 illustrates the compensation semiconductor layer A3 of the compensation transistor T3, which corresponds to a portion of the oxide semiconductor pattern 1410. The oxide semiconductor pattern 1410 may include an oxide semiconductor material.

The compensation semiconductor layer A3 may include a channel region C3 and conductive regions on sides (e.g., opposite sides) of the channel region C3, and FIG. 4 illustrates a region B3 that is one of conductive regions arranged on a side of the channel region C3. The compensation semiconductor layer A3 and the driving semiconductor layer A1 may be arranged on different layers. For example, the driving semiconductor layer A1 may be disposed on the buffer layer 111 and the compensation semiconductor layer A3 may be disposed on the first interlayer insulating layer 114. For example, a vertical distance from the substrate 100 to the compensation semiconductor layer A3 may be greater than a vertical distance from the substrate 100 to the driving semiconductor layer A1.

A third gate electrode G3 may be disposed below and/or on the compensation semiconductor layer A3. FIG. 4 illustrates the third gate electrode G3 including a lower compensation gate electrode G3a disposed below the compensation semiconductor layer A3 and an upper compensation gate electrode G3b disposed on the compensation semiconductor layer A3. One of the lower compensation gate electrode G3a and the upper compensation gate electrode G3b may be omitted.

The lower compensation gate electrode G3a and the upper electrode CE2 may include the same material and located on the same layer (for example, the second gate insulating layer 113). The upper compensation gate electrode G3b may be arranged on the compensation semiconductor layer A3 with a third gate insulating layer 115 therebetween. The upper compensation gate electrode G3b may include Al, Pt, Pd, Ag, Mg, Au, Ni, Nd, Ir, Cr, Li, Ca, Mo, Ti, W, and/or Cu, and may be formed in a single layer or a multilayer including the above material.

FIG. 4 illustrates that the third gate insulating layer 115 is arranged only between the upper compensation gate electrode G3b and the compensation semiconductor layer A3, but it is not limited thereto. The third gate insulating layer 115 may be formed to cover (e.g., entirely cover) the substrate 100 like another insulating layer, such as the first gate insulating layer 112. The third gate insulating layer 115 may be an inorganic insulating layer including an inorganic insulating material, such as silicon oxide, silicon nitride, or silicon oxynitride, and may include a single layer structure or a multilayer structure including the above material.

A second interlayer insulating layer 116 may be disposed on the upper compensation gate electrode G3b. The second interlayer insulating layer 116 may be an inorganic insulating layer including an inorganic insulating material, such as silicon oxide, silicon nitride, or silicon oxynitride, and may include a single layer structure or a multilayer structure including the above material.

The first connection electrode 1630 and the compensation scan line GCL may be disposed on the second interlayer insulating layer 116. The first connection electrode 1630 and the compensation scan line GCL may each include Al, Pt, Pd, Ag, Mg, Au, Ni, Nd, Ir, Cr, Li, Ca, Mo, Ti, W, and/or Cu, and may each be formed in a single layer or a multilayer including the above material. The first connection electrode 1630 and the compensation scan line GCL may each have a three-layer structure of Al layer/Ti layer/Al layer. The compensation scan line GCL may be electrically connected to the upper compensation gate electrode G3b through a contact hole penetrating through the second interlayer insulating layer 116.

A first via insulating layer 121 may be disposed on the first connection electrode 1630 and the compensation scan line GCL. The first via insulating layer 121 may be disposed on the second interlayer insulating layer 116 while covering the first connection electrode 1630 and the compensation scan line GCL. The first via insulating layer 121 may be referred to as a first planarization layer providing a substantially flat top surface.

The first via insulating layer 121 may include an organic insulating material. For example, the first via insulating layer 121 may include photoresist, benzocyclobutene (BCB), polyimide, hexamethyldisiloxane (HMDSO), polymethylmethacrylate (PMMA), polystyrene, a polymer derivative having a phenol-based group, acryl-based polymer, imide-based polymer, arylether-based polymer, amide-based polymer, fluorine-based polymer, p-xylene-based polymer, vinyl alcohol-based polymer, or a compound thereof.

The driving voltage line PL may be disposed on the first via insulating layer 121. The driving voltage line PL may overlap the driving transistor T1 and the first capacitor Cst. The driving voltage line PL may overlap the compensation transistor T3. The driving voltage line PL may include Al, Pt, Pd, Ag, Mg, Au, Ni, Nd, Ir, Cr, Li, Ca, Mo, Ti, W, and/or Cu, and may be formed in a single layer or a multilayer including the above material. The driving voltage line PL may have a three-layer structure of Al layer/Ti layer/Al layer.

A second via insulating layer 123 may be disposed on the driving voltage line PL. The second via insulating layer 123 may be disposed on the first via insulating layer 121 while covering the driving voltage line PL. The second via insulating layer 123 may be referred to as a second planarization layer providing a substantially flat top surface.

The second via insulating layer 123 may include an organic insulating material. For example, the second via insulating layer 123 may include photoresist, BCB, polyimide, HMDSO, PMMA, polystyrene, a polymer derivative having a phenol-based group, acryl-based polymer, imide-based polymer, arylether-based polymer, amide-based polymer, fluorine-based polymer, p-xylene-based polymer, vinyl alcohol-based polymer, or a compound thereof.

The light-emitting diode LED may be disposed on the second via insulating layer 123. The light-emitting diode LED may include a pixel electrode 210, an intermediate layer 220, and an opposing electrode 230 on the second via insulating layer 123.

The pixel electrode 210 may be a semi-transmissive electrode, a transmissive electrode, or a reflective electrode. For example, the pixel electrode 210 may include a reflective layer including Ag, Mg, Al, Pt, Pd, Au, Ni, Nd, Ir, Cr, or a compound thereof, and a transparent or semi-transparent electrode layer on the reflective layer. The transparent or semi-transparent electrode layer may include at least one of indium tin oxide (ITO), indium zinc oxide (IZO), zinc oxide (ZnO), indium oxide (In₂O₃), indium gallium oxide (IGO), and aluminum zinc oxide (AZO). For example, the pixel electrode 210 may have a three-layer structure of ITO/Ag/ITO.

An edge portion of the pixel electrode 210 may be covered by a bank layer 130 and an inner portion of the pixel electrode 210 may overlap the intermediate layer 220 within a pixel opening 130OP of the bank layer 130. For example, the bank layer 130 may cover the edge portion of the pixel electrode 210 and define the pixel opening 130OP exposing a portion of the pixel electrode 210. The pixel opening 130OP of the bank layer 130 may define an emission area EA of the light-emitting diode LED.

The pixel electrode 210 may be formed for each light-emitting diode LED, while the opposing electrode 230 is formed in response to the light-emitting diodes LED. For example, the light-emitting diodes LED may share the opposing electrode 230, and a stack structure of the pixel electrode 210, the intermediate layer 220, and the opposing electrode 230 may correspond to the light-emitting diode LED.

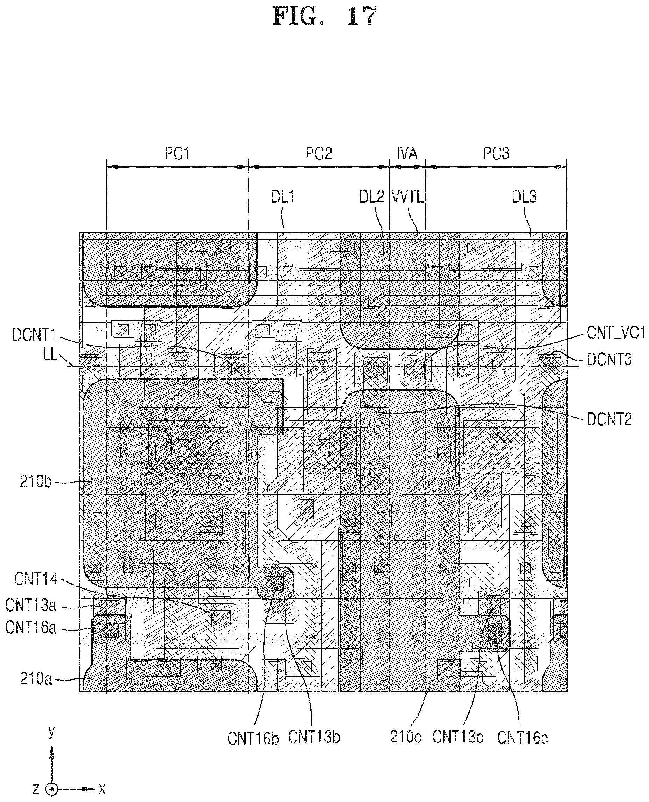

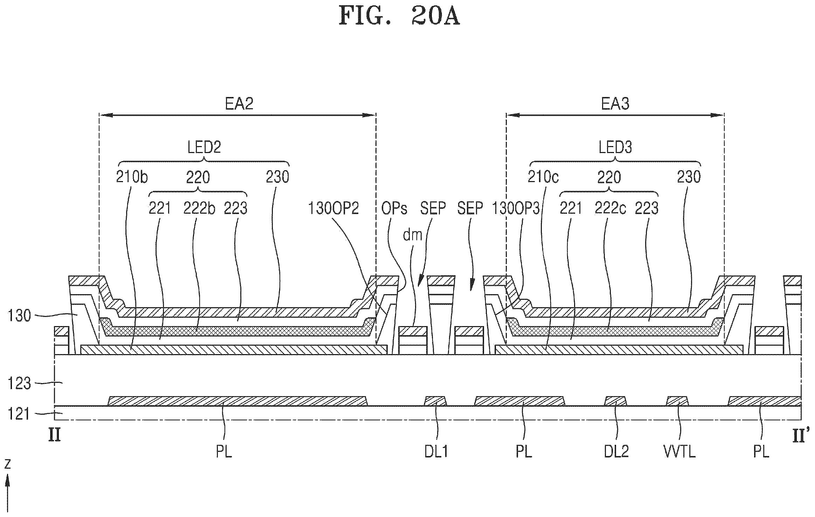

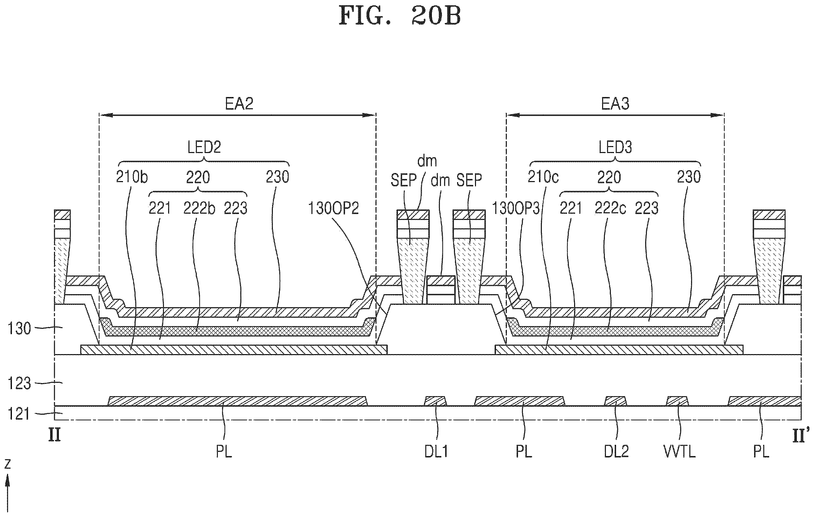

The intermediate layer 220 may be disposed on the pixel electrode 210. The intermediate layer 220 may include an emission layer 222, a first functional layer 221 disposed below the emission layer 222, and a second functional layer 223 disposed on the emission layer 222. The emission layer 222 may have a shape patterned according to the pixel electrode 210. For example, a first emission layer may be patterned according to a first pixel electrode 210a (see FIG. 17) described below, a second emission layer 222b (see FIG. 20) may be patterned according to a second pixel electrode 210b (see FIG. 17), and a third emission layer 222c (see FIG. 17) may be patterned according to a third pixel electrode 210c (see FIG. 20A). Each of the first emission layer, the second emission layer 222b (see FIG. 20A) and the third emission layer 222c (see FIG. 20A) may include a high-molecular weight or low-molecular weight organic material emitting light of a certain color. The first functional layer 221 may be a hole transport layer. In another example, the first functional layer 221 may include a hole injection layer and a hole transport layer. The second functional layer 223 may include an electron transport layer and/or an electron injection layer. The first functional layer 221 and the second functional layer 223 may be integrated to correspond to the light-emitting diodes LED. The first functional layer 221 or the second functional layer 223 may be omitted.

The intermediate layer 220 may include two or more emitting units that are sequentially stacked with each other, and a charge generation layer located between the two or more emitting units. In the case that the intermediate layer 220 includes the two or more emitting units and the charge generation layer, the light-emitting diode LED may be a tandem light-emitting element. The light-emitting diode LED may have a stack structure of emitting units, and thus have improved color purity and light-emitting efficiency.

An emitting unit may include the emission layer 222, and the first functional layer 221 and the second functional layer 223 respectively below and on the emission layer 222. The charge generation layer may include a negative charge generation layer and a positive charge generation layer. The light-emitting efficiency of the light-emitting diode LED that is the tandem light-emitting element including the emission layers 222 may be further increased by the negative charge generation layer and the positive charge generation layer.

The negative charge generation layer may be an n-type charge generation layer. The negative charge generation layer may supply electrons. The negative charge generation layer may include a host and a dopant. The host may include an organic material. The dopant may include a metal material. The positive charge generation layer may be a p-type charge generation layer. The positive charge generation layer may supply holes. The positive charge generation layer may include a host and a dopant. The host may include an organic material. The dopant may include a metal material.

The opposing electrode 230 may be disposed on the intermediate layer 220. The opposing electrode 230 may be a transparent electrode, a semi-transparent electrode, or a reflective electrode. For example, the opposing electrode 230 may include Li, Ag, Mg, Al, Al-Li, Ca, Mg-In, Mg-Ag, ytterbium (Yb), Ag-Yb, ITO, IZO, or an any combination thereof. The opposing electrode 230 may be integrated to correspond to the light-emitting diodes LED.

An encapsulation layer 300 may be disposed on the light-emitting diode LED. The encapsulation layer 300 may include at least one inorganic encapsulation layer and at least one organic encapsulation layer. FIG. 4 illustrates that the encapsulation layer 300 includes a first inorganic encapsulation layer 310, an organic encapsulation layer 320, and a second inorganic encapsulation layer 330.

The first inorganic encapsulation layer 310 and the second inorganic encapsulation layer 330 may each include an inorganic insulating material, such as silicon oxide (SiO₂), silicon nitride (SiNx), silicon oxynitride (SiON), aluminum oxide (Al₂O₃), titanium oxide (TiO₂), tantalum oxide (Ta₂O₅), hafnium oxide (HfO₂), or zinc oxide (ZnOₓ which may include ZnO and/or ZnO₂). The first inorganic encapsulation layer 310 and second inorganic encapsulation layer 330 may each have a single layer structure or a multilayer structure including the above inorganic insulating material.

The organic encapsulation layer 320 may relieve or reduce internal stress of the first inorganic encapsulation layer 310 and/or the second inorganic encapsulation layer 330. The organic encapsulation layer 320 may include a polymer-based material. Examples of the polymer-based material may include polyethylene terephthalate, polyethylene naphthalate, polycarbonate, polyimide, polyethylene sulfonate, polyoxymethylene, polyarylate, hexamethyldisiloxane, acrylic resins (e.g., polymethyl methacrylate, polyacrylic acid, etc.), and any combination thereof.

The organic encapsulation layer 320 may be formed by coating a material that has flowability and contains monomers and then combining the monomers by using heat or light such as ultraviolet rays to form a polymer. In another example, the organic encapsulation layer 320 may be formed by coating a polymer material.

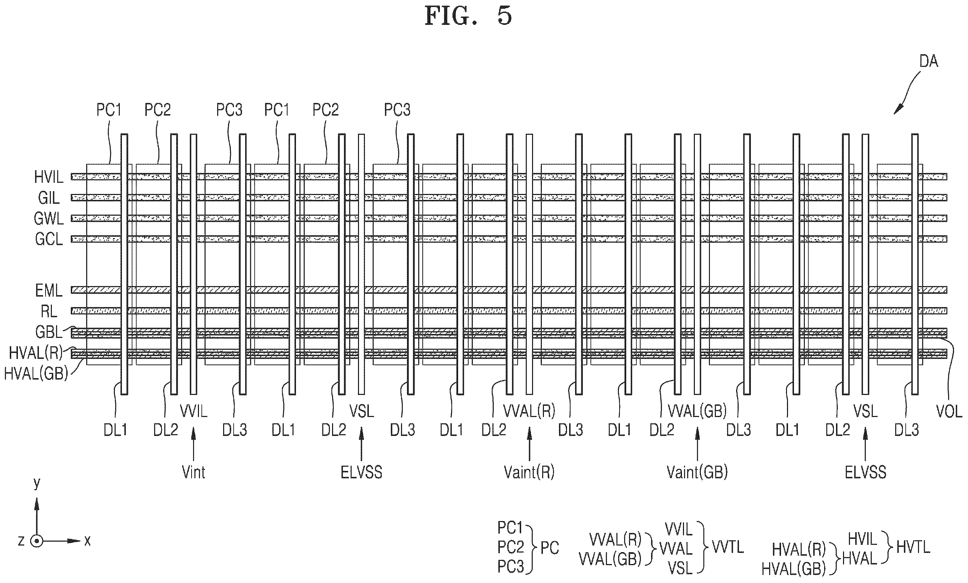

FIG. 5 is a schematic plan view showing a portion of wires arranged in the display area DA of the display device 1 (see FIG. 1). The pixel circuits PC may be arranged in the first direction (e.g., a y-axis direction) and the second direction (e.g., a ±x-axis direction) in the display area DA, and FIG. 5 illustrates the pixel circuits PC electrically connected to a pixels arranged in the same row, e.g., an i-th row.

The pixel circuits PC may be electrically connected to the light-emitting diodes LED (see FIG. 3) of sub-pixels, respectively. For example, a first pixel circuit PC1 may be electrically connected to a first light-emitting diode of a first sub-pixel, a second pixel circuit PC2 may be electrically connected to a second light-emitting diode of a second sub-pixel, and a third pixel circuit PC3 may be electrically connected to a third light-emitting diode of a third sub-pixel. Hereinafter, for convenience of description, the pixel circuits PC electrically and respectively connected to the first light-emitting diode, the second light-emitting diode, and the third light-emitting diode, which emit light of different colors, will be referred to as the first pixel circuit PC1, the second pixel circuit PC2, and third pixel circuit PC3.

Referring to FIG. 5, the first pixel circuit PC1, the second pixel circuit PC2, and the third pixel circuit PC3 may be repeatedly arranged in the second direction (e.g., the ±x-axis direction). The first pixel circuit PC1, the second pixel circuit PC2, and the third pixel circuit PC3 may be arranged in the second direction (e.g., the ±x-axis direction) in the stated order. For example, a distance between the second pixel circuit PC2 and the third pixel circuit PC3 may be greater than a distance between the second pixel circuit PC2 and the first pixel circuit PC1.

The display device 1 (see FIG. 1) may include lines arranged in the display area DA and electrically connected to the pixel circuits PC, for example, first conductive lines (hereinafter, referred to as horizontal conductive lines) extending in the second direction (e.g., the ±x-axis direction) and second conductive lines (hereinafter, referred to as vertical conductive lines) extending in the first direction (e.g., the ±y-axis direction).

The horizontal conductive lines extending in the second direction (e.g., the ±x-axis direction) may include horizontal voltage lines HVTL, the first initialization control line GIL, the scan line GWL, the compensation scan line GCL, the emission control line EML, a repair line RL, the second initialization control line GBL, and the bias voltage line VOL. The horizontal voltage lines HVTL may be wires electrically connected to vertical voltage lines VVTL described below, respectively. The horizontal voltage lines HVTL may include a first initialization horizontal voltage line HVIL and a second initialization horizontal voltage line HVAL. The second initialization horizontal voltage line HVAL may include a second-first initialization horizontal voltage line HVAL(R) and a second-second initialization horizontal voltage line HVAL(GB). The first initialization horizontal voltage line HVIL, the second-first initialization horizontal voltage line HVAL(R), and the second-second initialization horizontal voltage line HVAL(GB) may be arranged on different layers.

The vertical conductive lines extending in the first direction (e.g., the ±y-axis direction) may include the vertical voltage line VVTL, a first data line DL1, a second data line DL2, and a third data line DL3. The vertical voltage line VVTL may include a first initialization vertical voltage line VVIL, the common voltage line VSL that provides the common voltage ELVSS, and a second initialization vertical voltage line VVAL. The second initialization vertical voltage line VVAL may include a second-first initialization vertical voltage line VVAL(R) and a second-second initialization vertical voltage line VVAL(GB).

The first initialization vertical voltage line VVIL and the first initialization horizontal voltage line HVIL, which provide the first initialization voltage Vint, may be electrically connected to each other in the display area DA. The second-first initialization horizontal voltage line HVAL(R) and the second-first initialization vertical voltage line VVAL(R), which provide a second-first initialization voltage Vaint(R) to the first pixel circuit PC1, may be electrically connected to each other in the display area DA. The second-second initialization vertical voltage line VVAL(GB) and the second-second initialization horizontal voltage line HVAL(GB), which provide a second-second initialization voltage Vaint(GB) respectively to the second pixel circuit PC2 and the third pixel circuit PC3, may be electrically connected to each other in the display area DA.

In FIG. 5, the second pixel circuit PC2 and the third pixel circuit PC3 may be electrically connected to the same voltage line, e.g., the second-second initialization vertical voltage line VVAL(GB) and/or the second-second initialization horizontal voltage line HVAL(GB), but are not limited thereto. Horizontal and vertical voltage lines that apply a second initialization voltage to the second pixel circuit PC2, and horizontal and vertical voltage lines that apply the second initialization voltage to the third pixel circuit PC3 may independently exist or be separated from each other.

The first data line DL1, the second data line DL2, and the third data line DL3 may be electrically connected to the first pixel circuit PC1, the second pixel circuit PC2, and the third pixel circuit PC3, respectively. The first data line DL1, the second data line DL2, and the third data line DL3 may transmit the data signal Dm (see FIG. 3) respectively to the first pixel circuit PC1, the second pixel circuit PC2, and the third pixel circuit PC3.

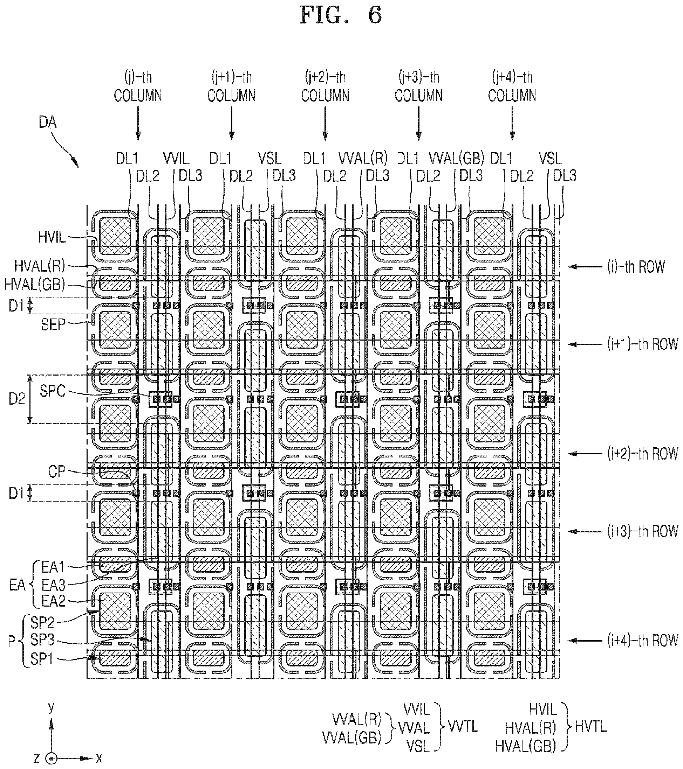

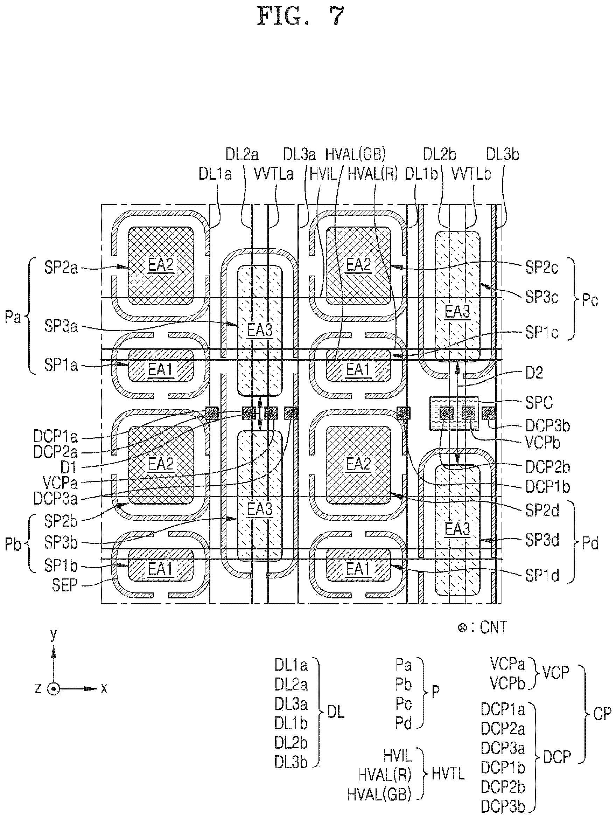

FIG. 6 is a schematic plan view showing arrangements of wires and emission areas EA of pixels P, which are arranged in the display area DA of the display device 1 (see FIG. 1). FIG. 7 is an enlarged schematic view of a partial area of FIG. 6. FIG. 7 is an enlarged schematic view of four pixels, i.e., a first pixel Pa, a second pixel Pb, a third pixel Pc, and a fourth pixel Pd, which are arranged adjacent to each other, from among the pixels P of FIG. 6. FIG. 6 illustrates arrangements of some horizontal conductive lines and vertical conductive lines from among the wires described with reference to FIG. 5.

Referring to FIGS. 6 and 7, each of the pixels P may include a first sub-pixel SP1, a second sub-pixel SP2, and a third sub-pixel SP3. The first sub-pixel SP1, the second sub-pixel SP2, and the third sub-pixel SP3 may emit light of different colors respectively through a first light-emitting diode, a second light-emitting diode LED2 (see FIG. 20A), and a third light-emitting diode LED3 (see FIG. 20A). For example, the first sub-pixel SP1 may be a red sub-pixel emitting red light, the second sub-pixel SP2 may be a green sub-pixel emitting green light, and the third sub-pixel SP3 may be a blue sub-pixel emitting blue light.

The pixels P may be arranged in the first direction (e.g., the y-axis direction) and the second direction (e.g., the x-axis direction). For example, the pixels P may be arranged in the form of a matrix including pixel columns extending in the first direction (e.g., the y-axis direction) and pixel rows extending in the second direction (e.g., the ±x-axis direction).

For example, as shown in FIG. 7, the pixels P may include the first pixel Pa, the second pixel Pb, the third pixel Pc, and the fourth pixel Pd. The first pixel Pa and the second pixel Pb may be arranged in the first direction, and the third pixel Pc and the fourth pixel Pd may be arranged in the first direction on a different column from the first pixel Pa and the second pixel Pb. The first pixel Pa and the third pixel Pc may be arranged in the second direction, and the second pixel Pb and the fourth pixel Pd may be arranged in the second direction on a different row from the first pixel Pa and the third pixel Pc. The second pixel Pb may be adjacent to the first pixel Pa in the first direction, the third pixel Pc may be adjacent to the first pixel Pa in the second direction, and the fourth pixel Pd may be adjacent to the third pixel Pc in the first direction and adjacent to the second pixel Pb in the second direction.

In each column, a first emission area EA1 of the first sub-pixel SP1 and a second emission area EA2 of the second sub-pixel SP2 may be alternately and repeatedly arranged in the first direction. For example, the second emission area EA2 of a second sub-pixel SP2a of the first pixel Pa, the first emission area EA1 of a first sub-pixel SP1a of the first pixel Pa, the second emission area EA2 of a second sub-pixel SP2b of the second pixel Pb, and the first emission area EA1 of a first sub-pixel SP1b of the second pixel Pb may be arranged in the first direction in the stated order. For example, the second emission area EA2 of a second sub-pixel SP2c of the third pixel Pc, the first emission area EA1 of a first sub-pixel SP1c of the third pixel Pc, the second emission area EA2 of a second sub-pixel SP2d of the fourth pixel Pd, and the first emission area EA1 of a first sub-pixel SP1d of the fourth pixel Pd may be arranged in the first direction in the stated order.

In each column, a third emission area EA3 of the third sub-pixel SP3 may be repeatedly arranged in the first direction. For example, the third emission area EA3 of a third sub-pixel SP3a of the first pixel Pa and the third emission area EA3 of a third sub-pixel SP3b of the second pixel Pb may be arranged in the first direction in the stated order. For example, the third emission area EA3 of a third sub-pixel SP3c of the third pixel Pc and the third emission area EA3 of a third sub-pixel SP3d of the fourth pixel Pd may be arranged in the first direction in the stated order.

The third emission areas EA3 arranged on the same row in two adjacent columns may be shifted from each other. For example, the third emission area EA3 of the pixel P arranged in an i-th row and a j-th column, and the third emission area EA3 of the pixel P arranged in the i-th row and a (j+1)-th column may not be arranged on a straight line extending in the second direction but may be arranged in a diagonal direction.

In each column, the third emission areas EA3 may not be arranged at regular intervals. The third emission areas EA3 arranged in each column may be arranged alternately in a relatively small first distance D1 and a second distance D2 greater than the first distance D1. For example, in case that a distance between a pair of adjacent third emission areas EA3 is the first distance D1, a distance between one of the pair of third emission areas EA3 and the third emission area EA3 adjacent thereto in the first direction may be the second distance D2.

In case that the third emission areas EA3 arranged in the same row in two adjacent columns are shifted from each other, a distance between two third emission areas EA3 arranged in one column and a distance between two third emission areas EA3 arranged in another adjacent column may be different from each other for four third emission areas EA3 arranged in two adjacent rows and two adjacent columns. For example, as shown in FIG. 7, the first distance D1 between the third emission area EA3 of the third sub-pixel SP3a of the first pixel Pa and the third emission area EA3 of the third sub-pixel SP3b of the second pixel Pb may be less than the second distance D2 between the third emission area EA3 of the third sub-pixel SP3c of the third pixel Pc and the third emission area EA3 of a third sub-pixel SP3d of the fourth pixel Pd.

A shape of each of the first emission area EA1, the second emission area EA2, and the third emission area EA3 is a rectangle with round corners (e.g., vertexes), but is not limited thereto. For example, the shape of each of the first emission area EA1, the second emission area EA2, and the third emission area EA3 may be variously modified, for example, a polygon including a triangle, a rectangle, or the like, a circle, or an oval.

The first emission area EA1 of the first sub-pixel SP1, the second emission area EA2 of the second sub-pixel SP2, and the third emission area EA3 of the third sub-pixel SP3 may have different areas (e.g., sizes). The third emission area EA3 of the third sub-pixel SP3 may have a greater area (or greater size) than the first emission area EA1 of the first sub-pixel SP1. For example, the third emission area EA3 of the third sub-pixel SP3 may have a greater area (or greater size) than the second emission area EA2 of the second sub-pixel SP2. The second emission area EA2 of the second sub-pixel SP2 may have a greater area (or greater size) than the first emission area EA1 of the first sub-pixel SP1. The first emission area EA1 of the first sub-pixel SP1 may have the same area (or same size) as the second emission area EA2 of the second sub-pixel SP2.

The vertical voltage lines VVTL may be spaced apart from each other in the second direction and arranged on different columns. The first initialization vertical voltage line VVIL, the common voltage line VSL, the second-first initialization vertical voltage line VVAL(R), and the second-second initialization vertical voltage line VVAL(GB) may be spaced apart from each other and arranged on different columns. The first initialization vertical voltage line VVIL, the common voltage line VSL, the second-first initialization vertical voltage line VVAL(R), the second-second initialization vertical voltage line VVAL(GB), and the common voltage line VSL may be spaced apart from each other in the second direction in the stated order. For example, the first initialization vertical voltage line VVIL may be arranged on the j-th column, wherein j may be a natural number, the common voltage line VSL may be arranged on the (j+1)-th column, the second-first initialization vertical voltage line VVAL(R) may be arranged on a (j+2)-th column, second-second initialization vertical voltage line VVAL(GB) may be arranged on a (j+3)-th column, and common voltage line VSL may be arranged on a (j+4)-th column. However, this is only an example, and an arrangement order of the vertical voltage lines VVTL may be variously changed.

The display device 1 (see FIG. 1) may further include connection conductive patterns CP arranged in the display area DA. In FIGS. 6 and 7, the connection conductive patterns CP are located between emission areas EA and are spaced apart from the emission areas EA, but are not limited thereto. For example, at least a portion of each of the connection conductive patterns CP may be located between the emission areas EA and include a contact portion located between the emission areas EA. For example, a portion of each of the connection conductive patterns CP may be located between the emission areas EA and a remaining portion of each of the connection conductive patterns CP may overlap at least one of the emission areas EA.

The horizontal voltage lines HVTL may be electrically connected to the vertical voltage lines VVTL by the connection conductive patterns CP. In each row, the horizontal voltage lines HVTL may include the first initialization horizontal voltage line HVIL, the second-first initialization horizontal voltage line HVAL(R), and the second-second initialization horizontal voltage line HVAL(GB). For example, the horizontal voltage lines HVTL may include the second-first initialization horizontal voltage line HVAL(R), the first initialization horizontal voltage line HVIL, and the second-second initialization horizontal voltage line HVAL(GB), which are located in an i-th row, and include the second-first initialization horizontal voltage line HVAL(R), the first initialization horizontal voltage line HVIL, and the second-second initialization horizontal voltage line HVAL(GB), which are located in an (i+1)-th row. The horizontal voltage lines HVTL arranged in each row may be electrically connected to the vertical voltage line VVTL, and thus, a voltage may be transmitted, via the vertical voltage line VVTL, to each of the pixels P arranged in a matrix form.

The vertical conductive lines (e.g., the first data line DL1, the second data line DL2, and the third data line DL3 and the vertical voltage line VVTL) may be electrically connected to the connection conductive patterns CP, respectively, by a contact hole CNT. The vertical conductive lines may be arranged on the same layer (e.g., the first via insulating layer 121) as the driving voltage line PL described with reference to FIG. 4. The connection conductive patterns CP may be arranged on the same layer (e.g., the second interlayer insulating layer 116) as the compensation scan line GCL described with reference to FIG. 4. The first via insulating layer 121 described with reference to FIG. 4 may be located between the connection conductive patterns CP and the vertical conductive lines, and the contact hole CNT may be defined by the first via insulating layer 121. The contact hole CNT may be a through hole penetrating through the first via insulating layer 121 and may electrically respectively connect the connection conductive patterns CP to the vertical conductive lines. Each of the vertical conductive lines may include a contact portion connected to (or in contact with) the connection conductive pattern CP in the contact hole CNT, and details about the contact hole CNT may be understood as being identical to details about the contact portion of each vertical conductive line.

The connection conductive patterns CP may include a voltage connection pattern VCP electrically connected to the vertical voltage lines VVTL, and a data connection pattern DCP electrically connected to the first data line DL1, the second data line DL2, and the third data line DL3. The data connection pattern DCP may include first data connection patterns DCP1a and DCP1b electrically connected to the first data line DL1, second data connection patterns DCP2a and DCP2b electrically connected to the second data line DL2, and third data connection patterns DCP3a and DCP3b electrically connected to the third data line DL3.

The vertical voltage lines VVTL may be electrically connected to the horizontal voltage line HVTL through the voltage connection pattern VCP and may transmit a constant voltage (e.g., a first initialization voltage Vint, a second-first initialization voltage Vaint(R), or a second-second initialization voltage Vaint(GB) as described with reference to FIG. 5) to each of the pixels P. For example, in case that the vertical voltage line VVTL is the first initialization vertical voltage line VVIL, the vertical voltage line VVTL may be electrically connected to the first initialization horizontal voltage line HVIL through the voltage connection pattern VCP. For example, in case that the vertical voltage line VVTL is the second-first initialization vertical voltage line VVAL(R), the vertical voltage line VVTL may be electrically connected to the second-first initialization horizontal voltage line HVAL(R) through the voltage connection pattern VCP. For example, in case that the vertical voltage line VVTL is the second-second initialization vertical voltage line VVAL(GB), the vertical voltage line VVTL may be electrically connected to the second-second initialization horizontal voltage line HVAL(GB) through the voltage connection pattern VCP. In the case that the vertical voltage line VVTL is the common voltage line VSL, the vertical voltage line VVTL may be electrically connected to the voltage connection pattern VCP through the contact hole CNT but may not be connected to the horizontal conductive line arranged in the display area DA. However, for example the common voltage line VSL may transmit a common voltage ELVSS (see FIG. 5) to each of the pixels P, by being electrically connected to the opposing electrode 230 (see FIG. 4). The common voltage line VSL may be electrically connected to the horizontal conductive line extending in the second direction through the contact hole CNT, together with the voltage connection pattern VCP.

In a plan view, at least some of the contact holes CNT connecting the vertical voltage lines VVTL respectively to the connection conductive patterns CP may be located between the third emission areas EA3 spaced apart from each other by the first distance D1 that is relatively small. The remaining of the contact holes CNT connecting the vertical voltage lines VVTL respectively to the connection conductive patterns CP may be arranged in a row in the second direction with the contact holes CNT located between the third emission areas EA3 spaced apart from each other by the first distance D1. The contact holes CNT connecting the vertical voltage lines VVTL respectively to the connection conductive patterns CP may not overlap the first emission area EA1, the second emission area EA2, and the third emission area EA3. For example, in a plan view, the contact holes CNT connecting the vertical voltage lines VVTL respectively to the connection conductive patterns CP may be spaced apart from the first emission area EA1, the second emission area EA2, and the third emission area EA3.

The contact hole CNT connecting (or electrically connecting) A to B may indicate that A and B are connected (or electrically connected) to each other by the contact hole CNT. In another example, the contact hole CNT connecting (or electrically connecting) A to B may indicate that A and B are connected (or electrically connected) to each other by a contact portion of A or B arranged in the contact hole CNT.

As shown in FIG. 7, the contact hole CNT electrically connecting a second-first data line DL2a to a second-first data connection pattern DCP2a may be located between the third emission area EA3 of the third sub-pixel SP3a of the first pixel Pa and the third emission area EA3 of the third sub-pixel SP3b of the second pixel Pb. For example, the second-first data line DL2a may extend in the first direction to overlap the third emission area EA3 of the third sub-pixel SP3a of the first pixel Pa and the third emission area EA3 of the third sub-pixel SP3b of the second pixel Pb, and transmit the data voltage to the second sub-pixel SP2a of the first pixel Pa and the second sub-pixel SP2b of the second pixel Pb. For example, the second-first data connection pattern DCP2a may be electrically connected to the second sub-pixel SP2b of the second pixel Pb.

The contact hole CNT electrically connecting a second-second data line DL2b to a second-second data connection pattern DCP2b may be arranged in a row in the second direction together with the contact hole CNT electrically connecting the second-first data line DL2a to the second-first data connection pattern DCP2a. For example, the second-second data line DL2b may extend in the first direction to overlap the third emission area EA3 of the third sub-pixel SP3c of the third pixel Pc and the third emission area EA3 of the third sub-pixel SP3d of the fourth pixel Pd, and transmit the data voltage to the second sub-pixel SP2c of the third pixel Pc and the second sub-pixel SP2d of the fourth pixel Pd. For example, the second-second data connection pattern DCP2b may be electrically connected to the second sub-pixel SP2d of the fourth pixel Pd. The contact hole CNT electrically connecting the second-second data line DL2b to the second-second data connection pattern DCP2b may be located between the third emission area EA3 of the third sub-pixel SP3c of the third pixel Pc and the third emission area EA3 of the third sub-pixel SP3d of the fourth pixel Pd.

The contact hole CNT electrically connecting a first-first data line DL1a to a first-first data connection pattern DCP1a may be arranged in a row in the second direction together with the contact hole CNT connecting the second-first data line DL2a to the second-first data connection pattern DCP2a. The first-first data line DL1a may transmit the data voltage to the first sub-pixel SP1a of the first pixel Pa and the first sub-pixel SP1b of the second pixel Pb. The first-first data connection pattern DCP1a may be electrically connected to the first sub-pixel SP1b of the second pixel Pb.

The contact hole CNT electrically connecting a third-first data line DL3a to a third-first data connection pattern DCP3a may be arranged in a row in the second direction together with the contact hole CNT connecting the second-first data line DL2a to the second-first data connection pattern DCP2a. The third-first data line DL3a may transmit the data voltage to the third sub-pixel SP3a of the first pixel Pa and the third sub-pixel SP3b of the second pixel Pb. The third-first data connection pattern DCP3a may be electrically connected to the third sub-pixel SP3b of the second pixel Pb.

For example, the contact hole CNT electrically connecting a first-second data line DL1b to a first-second data connection pattern DCP1b, and the contact hole CNT electrically connecting a third-second data line DL3b to a third-second data connection pattern DCP3b may be arranged in a row in the second direction together with the contact hole CNT connecting the second-first data line DL2a to the second-first data connection pattern DCP2a. The first-second data line DL1b may transmit the data voltage to the first sub-pixel SP1c of the third pixel Pc and the first sub-pixel SP1d of the fourth pixel Pd, and the third-second data line DL3b may transmit the data voltage to the third sub-pixel SP3c of the third pixel Pc and the third sub-pixel SP3d of the fourth pixel Pd. The first-second data connection pattern DCP1b may be electrically connected to the first sub-pixel SP1d of the fourth pixel Pd, and the third-second data connection pattern DCP3b may be electrically connected to the third sub-pixel SP3d of the fourth pixel Pd.

The contact hole CNT electrically connecting a first vertical voltage line VVTLa to a first voltage connection pattern VCPa may be located between the third emission area EA3 of the third sub-pixel SP3a of the first pixel Pa and the third emission area EA3 of the third sub-pixel SP3b of the second pixel Pb. For example, the first vertical voltage line VVTLa may extend in the first direction to overlap the third emission area EA3 of the third sub-pixel SP3a of the first pixel Pa and the third emission area EA3 of the third sub-pixel SP3b of the second pixel Pb. The contact hole CNT electrically connecting the first vertical voltage line VVTLa to the first voltage connection pattern VCPa may be arranged in a row together with the contact holes CNT electrically connecting data lines DL to the data connection patterns DCP. For example, the contact hole CNT electrically connecting the first vertical voltage line VVTLa to the first voltage connection pattern VCPa may be arranged in a row in the second direction together with the contact hole CNT electrically connecting the second-first data line DL2a to the second-first data connection pattern DCP2a. The first vertical voltage line VVTLa may be located between the second-first data line DL2a and the third-first data line DL3a.

The contact hole CNT electrically connecting a second vertical voltage line VVTLb to a second voltage connection pattern VCPb may be arranged in a row in the second direction together with the contact hole CNT electrically connecting the first vertical voltage line VVTLa to the first voltage connection pattern VCPa, and may be located between the third emission area EA3 of the third sub-pixel SP3c of the third pixel Pc and the third emission area EA3 of the third sub-pixel SP3d of the fourth pixel Pd. For example, the second vertical voltage line VVTLb may extend in the first direction to overlap the third emission area EA3 of the third sub-pixel SP3c of the third pixel Pc and the third emission area EA3 of the third sub-pixel SP3d of the fourth pixel Pd. The contact hole CNT electrically connecting the second vertical voltage line VVTLb to the second voltage connection pattern VCPb may be arranged in a row together with the contact holes CNT electrically connecting data lines DL to data connection patterns DCP. For example, the contact hole CNT electrically connecting the second vertical voltage line VVTLb to the second voltage connection pattern VCPb may be arranged in a row in the second direction together with the contact hole CNT electrically connecting the second-first data line DL2a to the second-first data connection pattern DCP2a. The second vertical voltage line VVTLb may be located between the second-second data line DL2b and the third-second data line DL3b.

The first vertical voltage line VVTLa and the second vertical voltage line VVTLb may be the vertical voltage lines VVTL arranged respectively in two adjacent columns. The first vertical voltage line VVTLa and the second vertical voltage line VVTLb may be different types of vertical voltage lines. For example, the first vertical voltage line VVTLa may transmit a first voltage that is a constant voltage to the first pixel Pa, the second pixel Pb, the third pixel Pc, and the fourth pixel Pd, and the second vertical voltage line VVTLb may transmit a second voltage that is a constant voltage to the first pixel Pa, the second pixel Pb, the third pixel Pc, and the fourth pixel Pd. For example, the first vertical voltage line VVTLa may be any one of the first initialization vertical voltage line VVIL, the common voltage line VSL, the second-first initialization vertical voltage line VVAL(R), and the second-second initialization vertical voltage line VVAL(GB), and the second vertical voltage line VVTLb may be another one of the first initialization vertical voltage line VVIL, the common voltage line VSL, the second-first initialization vertical voltage line VVAL(R), and the second-second initialization vertical voltage line VVAL(GB).

A connection between the first voltage connection pattern VCPa and the horizontal voltage line HVTL is omitted in FIG. 7, but as shown in FIG. 6, the vertical voltage line VVTL (e.g., the first vertical voltage line VVTLa) may be electrically connected to one of the horizontal voltage lines HVTL. For example, the first vertical voltage line VVTLa may be electrically connected to the first horizontal voltage line (e.g., one of the first initialization horizontal voltage line HVIL, the second-first initialization horizontal voltage line HVAL(R), and the second-second initialization horizontal voltage line HVAL(GB)) by the first voltage connection pattern VCPa. A connection between the second voltage connection pattern VCPb and the horizontal voltage line HVTL is omitted in FIG. 7, but as shown in FIG. 6, the vertical voltage line VVTL (e.g., the second vertical voltage line VVTLb) may be electrically connected to one of the horizontal voltage lines HVTL. For example, the second vertical voltage line VVTLb may be electrically connected to the second horizontal voltage line (e.g., one of the first initialization horizontal voltage line HVIL, the second-first initialization horizontal voltage line HVAL(R), and the second-second initialization horizontal voltage line HVAL(GB)) by the second voltage connection pattern VCPb. The first horizontal voltage line and the second horizontal voltage line may be different wires arranged on different layers. For example, the first vertical voltage line VVTLa may be electrically connected to the first horizontal voltage lines respectively arranged on rows, and thus may transmit the first voltage to each of the pixels P including the first pixel Pa, the second pixel Pb, the third pixel Pc, and the fourth pixel Pd. For example, the second vertical voltage line VVTLb may be electrically connected to the second horizontal voltage lines respectively arranged on rows, and thus may transmit the second voltage to each of the pixels P including the first pixel Pa, the second pixel Pb, the third pixel Pc, and the fourth pixel Pd.

In the case that the light-emitting diodes LED (see FIG. 4) of the pixels P are tandem light-emitting elements, functional layers including the intermediate layer 220 may have relatively high electric conductivity. The display device 1 (see FIG. 1) may further include separators SEP that reduce a leakage current between the adjacent light-emitting diodes LED. In a plan view, the separators SEP may include a separator surrounding the first emission area EA1, a separator surrounding the second emission area EA2, and a separator surrounding a pair of third emission areas EA3. A distance between the pair of third emission areas EA3 surrounded by one separator may be the first distance D1. For example, as shown in FIG. 7, one separator from among separators SEP may surround the third emission area EA3 of the third sub-pixel SP3a of the first pixel Pa and the third emission area EA3 of the third sub-pixel SP3b of the second pixel Pb. However, the separators SEP may not surround (e.g., completely surround) the first emission area EA1, the second emission area EA2, and the pair of third emission areas EA3, and thus, the opposing electrode 230 (see FIG. 4) may be connected to and integrated with each other in the display area DA.

The display device 1 (see FIG. 1) may further include spacers SPC. In a plan view, the spacer SPC may be located between a pair of third emission areas EA3 and another pair of third emission areas EA3, which are each surrounded by a separator (e.g., single separator). For example, in a plan view, the spacer SPC may be located between the pair of third emission areas EA3 surrounded by one separator SEP and the third emission area EA3 spaced apart from the pair of third emission areas EA3 by the second distance D2 in the first direction. For example, as shown in FIG. 7, the spacer SPC may be located between the third emission area EA3 of the third sub-pixel SP3c of the third pixel Pc and the third emission area EA3 of the third sub-pixel SP3d of the fourth pixel Pd.

The spacer SPC may overlap the contact hole CNT electrically connecting the vertical voltage line VVTL to the connection conductive pattern CP located between the third emission areas EA3 spaced apart from each other by the second distance D2. For example, as shown in FIG. 7, the contact hole CNT connecting the second-second data connection pattern DCP2b to the second-second data line DL2b and/or the contact hole CNT connecting the second voltage connection pattern VCPb to the second vertical voltage line VVTLb, which are located between the third emission area EA3 of the third sub-pixel SP3c of the third pixel Pc and the third emission area EA3 of the third sub-pixel SP3d of the fourth pixel Pd, may overlap the spacer SPC.

The spacer SPC may be disposed on the bank layer 130 described with reference to FIG. 4. The spacer SPC and the bank layer 130 (see FIG. 4) may include the same material. For example, the bank layer 130 (see FIG. 4) and the spacer SPC may be formed together during a process using a halftone mask or the like, and thus, the spacer SPC may have an island shape protruding from the bank layer 130 (see FIG. 4) at a certain interval in a z-axis direction. The spacer SPC may include a different material from the bank layer 130 (see FIG. 4). For example, the spacer SPC may include insulating patterns of island shapes disposed on the bank layer 130 (see FIG. 4) at certain intervals (or certain distances).

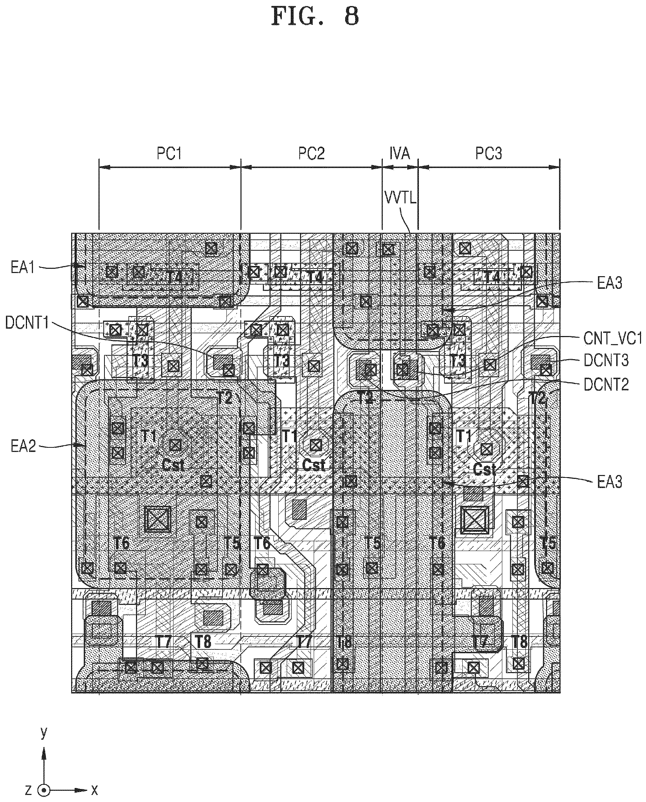

FIG. 8 is a schematic plan view showing an excerpt of the first pixel circuit PC1, the second pixel circuit PC2, and the third pixel circuit PC3 of the display device 1. The first pixel circuit PC1, the second pixel circuit PC2, and the third pixel circuit PC3 shown in FIG. 8 may be respectively electrically connected to the first sub-pixel SP1, the second sub-pixel SP2, and the third sub-pixel SP3 (see FIG. 6) of the pixel P (see FIG. 6) arranged in the i-th row and the j-th column. The first pixel circuit PC1, the second pixel circuit PC2, and the third pixel circuit PC3 may be arranged in the second direction.

Referring to FIG. 8, each of the first pixel circuit PC1, the second pixel circuit PC2, and the third pixel circuit PC3 may include a plurality of transistors and a capacitor. FIG. 8 illustrates the first pixel circuit PC1, the second pixel circuit PC2, and the third pixel circuit PC3 each including the eight transistors T1, T2, T3, T4, T5, T6, T7, and T8 and the first capacitor Cst, which are described above with reference to FIG. 3.

The driving transistor T1 may overlap the first capacitor Cst. Switching transistors (e.g., the transistors T2 to T8) may be arranged at an upper side and/or a lower side in a plan view, based on the driving transistor T1 and/or the first capacitor Cst. FIG. 8 illustrates, in a plan view, the data write transistor T2, the compensation transistor T3, and the first initialization transistor T4 arranged at the upper side (e.g., the +y-axis direction) of the driving transistor T1 and/or the first capacitor Cst. The operation control transistor T5, the emission control transistor T6, the second initialization transistor T7, and the bias transistor T8 may be arranged, in a plan view, at the lower side (e.g., the -y-axis direction) of the driving transistor T1 and/or the first capacitor Cst.

The first pixel circuit PC1, the second pixel circuit PC2, and the third pixel circuit PC3 may be arranged in the second direction, and a first distance between the second pixel circuit PC2 and the third pixel circuit PC3 may be greater than a second distance between the first pixel circuit PC1 and the second pixel circuit PC2. The vertical voltage line VVTL may be arranged in a space (hereinafter, a separated space IVA) between the second pixel circuit PC2 and the third pixel circuit PC3 having the first distance. The vertical voltage line VVTL shown in FIG. 8 may be the first initialization vertical voltage line VVIL, the common voltage line VSL, the second-first initialization vertical voltage line VVAL(R), and/or the second-second initialization vertical voltage line VVAL(GB) described above with reference to FIGS. 5 and 6.

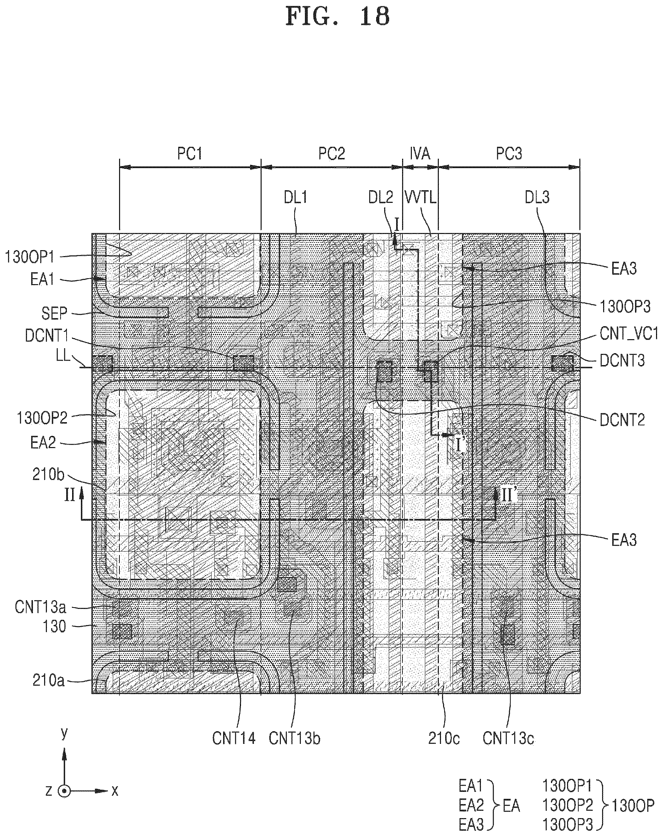

FIG. 8 illustrates regions respectively corresponding to the first emission area EA1 of a first organic light-emitting diode electrically connected to the first pixel circuit PC1, the second emission area EA2 of a second organic light-emitting diode electrically connected to the second pixel circuit PC2, and the third emission area EA3 of a third organic light-emitting diode electrically connected to the third pixel circuit PC3 in which the first pixel electrode 210a (see FIG. 17) the second pixel electrode 210b (see FIG. 17), and the third pixel electrode 210c (see FIG. 17) are respectively arranged, and does not illustrate the bank layer 130 shown with reference to FIG. 18.

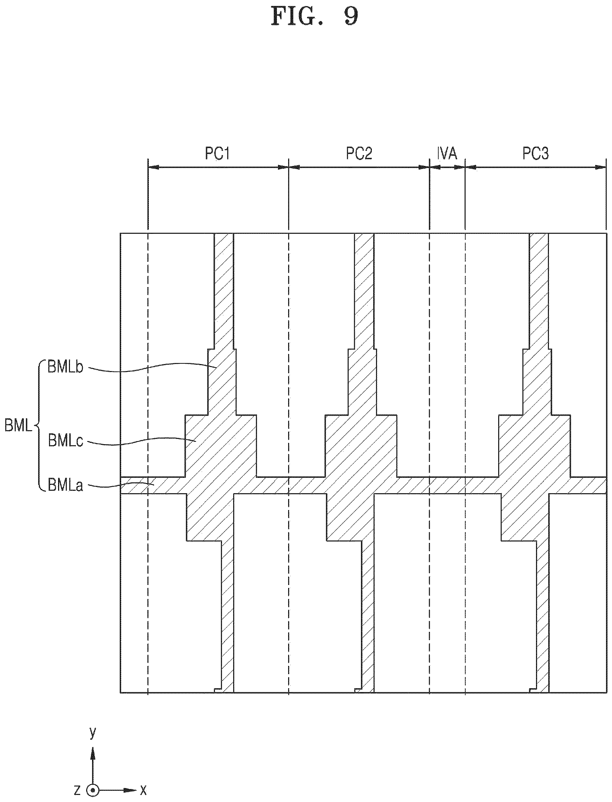

FIGS. 9 to 18 are plan views according to processes of forming the first pixel circuit PC1, the second pixel circuit PC2, and the third pixel circuit PC3 of FIG. 8.

Referring to FIG. 9, the lower metal layer BML may be disposed on the substrate 100 (see FIG. 4). The lower metal layer BML may include main portions BMLc respectively corresponding to the first pixel circuit PC1, the second pixel circuit PC2, and the third pixel circuit PC3. The lower metal layer BML may include first branch portions BMLa connecting the main portions BMLc in the second direction (e.g., the ±x-axis direction) and second branch portions BMLb connecting the main portions BMLc arranged respectively in pixel circuits electrically connected to pixels arranged in different rows in the first direction (e.g., the y-axis direction). The main portion BMLc, the first branch portion BMLa, and the second branch portion BMLb may be integral with each other.

The lower metal layer BML may be electrically connected to the driving voltage line PL (see FIG. 4) and have the same voltage level as the driving voltage line PL (see FIG. 4).

The lower metal layer BML may include one or more materials selected from aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and copper (Cu). The lower metal layer BML may be a Mo single layer, may have a double layer structure in which a Mo layer and a Ti layer are stacked with each other, or may have a triple layer structure in which a Ti layer, an Al layer, and a Ti layer are stacked with each other.

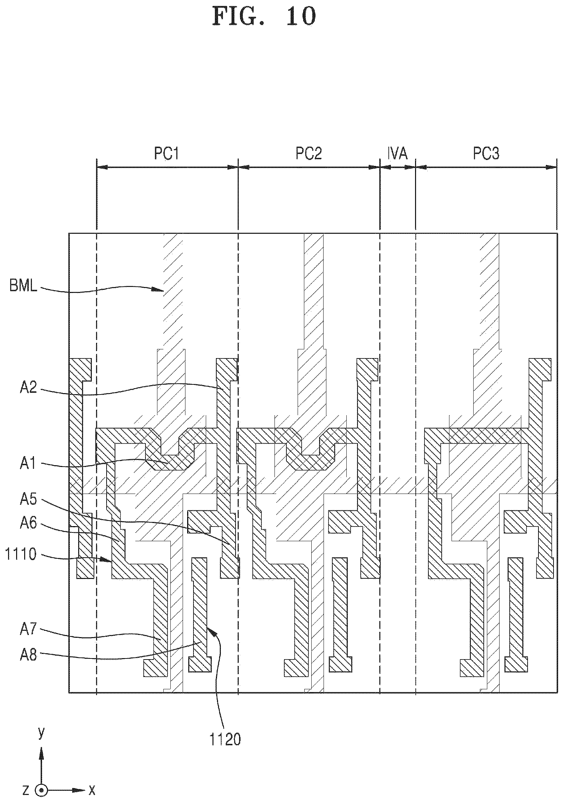

Referring to FIGS. 9 and 10, the buffer layer 111 (see FIG. 4) may be disposed on the lower metal layer BML and a first semiconductor layer may be disposed on the buffer layer 111 (see FIG. 4). The first semiconductor layer may include the first silicon semiconductor pattern 1110 and a second silicon semiconductor pattern 1120. The first silicon semiconductor pattern 1110 and the second silicon semiconductor pattern 1120 may be arranged on the same layer (e.g., the buffer layer 111).

The first silicon semiconductor pattern 1110 and the second silicon semiconductor pattern 1120 may be arranged in response to each of the first pixel circuit PC1, the second pixel circuit PC2, and the third pixel circuit PC3. The first silicon semiconductor patterns 1110 respectively arranged in the first pixel circuit PC1, the second pixel circuit PC2, and the third pixel circuit PC3 may be separated and spaced apart from each other. The first silicon semiconductor pattern 1110 and the second silicon semiconductor pattern 1120, which correspond to the same pixel circuit, may be spaced apart from each other, but are not limited thereto. The first silicon semiconductor pattern 1110 and the second silicon semiconductor pattern 1120, which correspond to the same pixel circuit, may be integral with each other.

The first silicon semiconductor pattern 1110 may include the driving semiconductor layer A1 of the driving transistor T1 (see FIG. 8), the semiconductor layer (hereinafter, a data write semiconductor layer A2) of the data write transistor T2 (see FIG. 8), the semiconductor layer (hereinafter, an operation control semiconductor layer A5) of the operation control transistor T5 (see FIG. 8), the semiconductor layer (hereinafter, an emission control semiconductor layer A6) of the emission control transistor T6 (see FIG. 8), and the semiconductor layer (hereinafter, a second initialization semiconductor layer A7) of the second initialization transistor T7 (see FIG. 8). The second silicon semiconductor pattern 1120 may include the semiconductor layer (hereinafter, a bias semiconductor layer A8) of the bias transistor T8 (see FIG. 8).

The first silicon semiconductor pattern 1110 and the second silicon semiconductor pattern 1120 may include amorphous silicon or polysilicon. For example, the first silicon semiconductor pattern 1110 and the second silicon semiconductor pattern 1120 may include polysilicon crystalized at a low temperature.

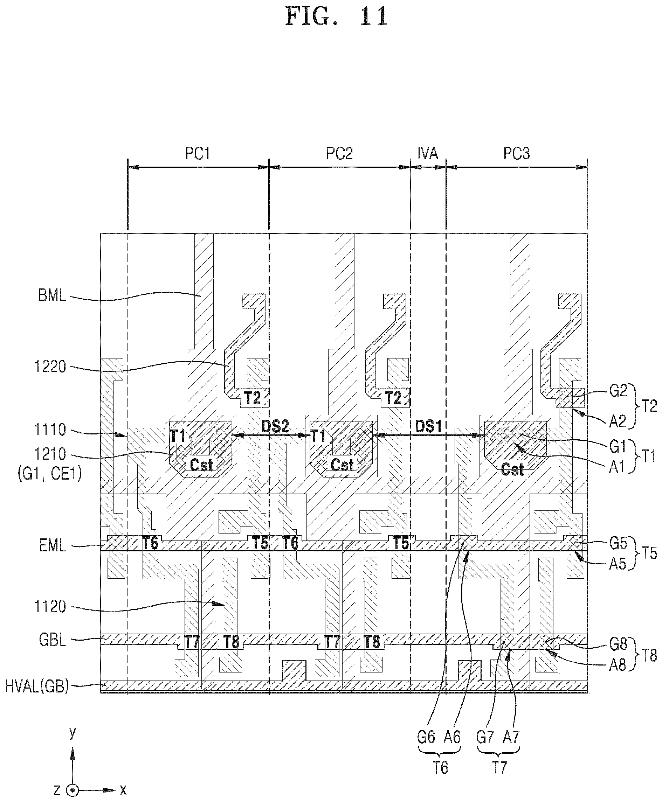

Referring to FIGS. 10 and 11, the first gate insulating layer 112 (see FIG. 4) may be disposed on the first silicon semiconductor pattern 1110 and the second silicon semiconductor pattern 1120, and a first conductive layer (or a first gate layer) may be disposed on the first gate insulating layer 112 (see FIG. 4). The first conductive layer (or the first gate layer) may include the first conductive pattern 1210, a second conductive pattern 1220, the emission control line EML, the second initialization control line GBL, and the second-second initialization horizontal voltage line HVAL(GB). The first conductive pattern 1210, the second conductive pattern 1220, the emission control line EML, the second initialization control line GBL, and the second-second initialization horizontal voltage line HVAL(GB) may be arranged on the same layer (e.g., the first gate insulating layer 112 (see FIG. 4)).

The first conductive pattern 1210, the second conductive pattern 1220, the emission control line EML, the second initialization control line GBL, and the second-second initialization horizontal voltage line HVAL(GB) may include the same material. The first conductive pattern 1210, the second conductive pattern 1220, the emission control line EML, the second initialization control line GBL, and the second-second initialization horizontal voltage line HVAL(GB) may include Al, Pt, Pd, Ag, Mg, Au, Ni, Nd, Ir, Cr, Li, Ca, Mo, Ti, W, and/or Cu, and may be formed in a single layer or a multilayer including the above material.

Each of the first conductive pattern 1210, the second conductive pattern 1220, the emission control line EML, and the second initialization control line GBL may include a gate electrode overlapping the first silicon semiconductor pattern 1110 and/or the second silicon semiconductor pattern 1120.

The first conductive pattern 1210 may be arranged in each of the first pixel circuit PC1, the second pixel circuit PC2, and the third pixel circuit PC3 and have an isolated shape. The first conductive pattern 1210 may include the driving gate electrode G1 of the driving transistor T1. The driving semiconductor layer A1 may include a channel region overlapping the first conductive pattern 1210 that is the driving gate electrode G1, and a source region and a drain region arranged on sides (e.g., opposite sides) of the channel region. Referring to FIGS. 9 and 10, the channel region of the driving semiconductor layer A1 may overlap a portion (e.g., the main portion BMLc) of the lower metal layer BML. The channel region of the driving semiconductor layer A1 of each of the first pixel circuit PC1 and the second pixel circuit PC2 may have a shape bent a plurality of times (e.g., an omega shape). The channel region of the driving semiconductor layer A1 of the third pixel circuit PC3 may have a straight shape considering efficiency of the third light-emitting diode electrically connected to the third pixel circuit PC3.

A distance between the second pixel circuit PC2 and the third pixel circuit PC3 being greater than a distance between the second pixel circuit PC2 and the first pixel circuit PC1 may be verified from (or may correspond to) a distance between the driving transistor T1 of the second pixel circuit PC2 and the driving transistor T1 of the third pixel circuit PC3 being greater than a distance between the driving transistor T1 of the second pixel circuit PC2 and the driving transistor T1 of the first pixel circuit PC1. For example, it may be verified from (or may correspond to) a first distance DS1 between the channel region of the driving transistor T1 of the second pixel circuit PC2 and the channel region of the driving transistor T1 of the third pixel circuit PC3, which is measured in the second direction (e.g., the ±x-axis direction), being greater than a second distance DS2 between the channel region of the driving transistor T1 of the second pixel circuit PC2 and the channel region of the driving transistor T1 of the first pixel circuit PC1, which is measured in the second direction (e.g., the ±x-axis direction). For example, it may be verified from (or may correspond to) the first distance DS1 between the driving gate electrode G1 of the driving transistor T1 of the second pixel circuit PC2 and the driving gate electrode G1 of the driving transistor T1 of the third pixel circuit PC3, which is measured in the second direction (e.g., the ±x-axis direction), being greater than the second distance DS2 between the driving gate electrode G1 of the driving transistor T1 of the second pixel circuit PC2 and the driving gate electrode G1 of the driving transistor T1 of the first pixel circuit PC1, which is measured in the second direction (e.g., the ±x-axis direction)..

The first conductive pattern 1210 may include the lower electrode CE1 of the first capacitor Cst. The first conductive pattern 1210 may include the driving gate electrode G1 and/or the lower electrode CE1 of the first capacitor Cst.

The second conductive pattern 1220 may be arranged in each of the first pixel circuit PC1, the second pixel circuit PC2, and the third pixel circuit PC3 and have an isolated shape. The second conductive pattern 1220 may include a second gate electrode G2 of the data write transistor T2. The data write semiconductor layer A2 may include a channel region overlapping the second gate electrode G2 of the data write transistor T2, and a source region and a drain region arranged on sides (e.g., opposite sides) of the channel region.

The emission control line EML may extend through the first pixel circuit PC1, the second pixel circuit PC2, and the third pixel circuit PC3 in the second direction (e.g., the ±x-axis direction). The emission control line EML may include an operation control gate electrode G5 of the operation control transistor T5 and an emission control gate electrode G6 of the emission control transistor T6. The operation control semiconductor layer A5 may include a channel region overlapping the operation control gate electrode G5, and a source region and a drain region arranged on sides (e.g., opposite sides) of the channel region. The emission control semiconductor layer A6 may include a channel region overlapping the emission control gate electrode G6, and a source region and a drain region arranged on sides (e.g., opposite sides) of the channel region.

The second initialization control line GBL may extend through the first pixel circuit PC1, the second pixel circuit PC2, and the third pixel circuit PC3 in the second direction (e.g., the ±x-axis direction). The second initialization control line GBL may include a second initialization gate electrode G7 of the second initialization transistor T7 and a bias gate electrode G8 of the bias transistor T8. The second initialization semiconductor layer A7 may include a channel region overlapping the second initialization gate electrode G7, and a source region and a drain region arranged on sides (e.g., opposite sides) of the channel region. The bias semiconductor layer A8 may include a channel region overlapping the bias gate electrode G8, and a source region and a drain region arranged on sides (e.g., opposite sides) of the channel region.

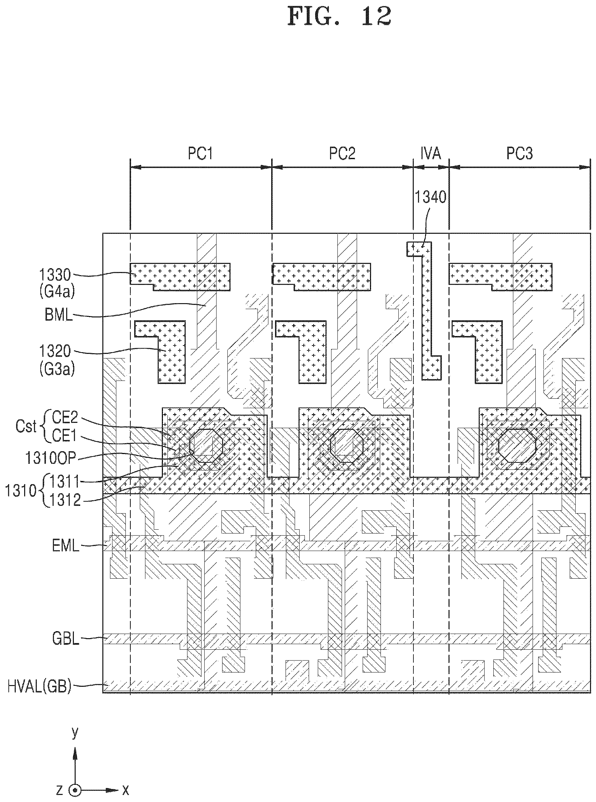

Referring to FIGS. 11 and 12, the second gate insulating layer 113 (see FIG. 4) may be disposed on the first conductive pattern 1210, the second conductive pattern 1220, the emission control line EML, the second initialization control line GBL, and the second-second initialization horizontal voltage line HVAL(GB), and a second conductive layer may be disposed on the second gate insulating layer 113(see FIG. 4). The second conductive layer may include the third conductive pattern 1310, a fourth conductive pattern 1320, a fifth conductive pattern 1330, and a bridge pattern 1340. The third conductive pattern 1310, the fourth conductive pattern 1320, the fifth conductive pattern 1330, and the bridge pattern 1340 may be arranged on the same layer (e.g., second gate insulating layer 113 (see FIG. 4)).

The third conductive pattern 1310, the fourth conductive pattern 1320,the fifth conductive pattern 1330, and the bridge pattern 1340 may include the same material. The third conductive pattern 1310, the fourth conductive pattern 1320, the fifth conductive pattern 1330, and the bridge pattern 1340 may include Al, Pt, Pd, Ag, Mg, Au, Ni, Nd, Ir, Cr, Li, Ca, Mo, Ti, W, and/or Cu, and may be formed in a single layer or a multilayer including the above material.

The third conductive pattern 1310 may be arranged to overlap the first conductive pattern 1210. The third conductive pattern 1310 may be a horizontal driving voltage line having a voltage level of a driving voltage ELVDD (see FIG. 3), and may extend in the second direction (e.g., the ±x-axis direction) through the first pixel circuit PC1, the second pixel circuit PC2, and the third pixel circuit PC3.

The third conductive pattern 1310 may include first portions 1311 overlapping the first conductive patterns 1210 respectively arranged in the first pixel circuit PC1, the second pixel circuit PC2, and the third pixel circuit PC3, and a second portion 1312 extending in the second direction (e.g., the x-axis direction) to connect the first portions 1311 respectively arranged in the first pixel circuit PC1, the second pixel circuit PC2, and the third pixel circuit PC3 to each other.

The first conductive pattern 1210 arranged in each of the first pixel circuit PC1, the second pixel circuit PC2, and the third pixel circuit PC3 may correspond to the lower electrode CE1 of the first capacitor Cst. The first portion 1311 of the third conductive pattern 1310 arranged in each of the first pixel circuit PC1, the second pixel circuit PC2, and the third pixel circuit PC3 may correspond to the upper electrode CE2 of the first capacitor Cst.

The third conductive pattern 1310 may overlap the lower metal layer BML. Referring to FIGS. 9 and 12, the first portion 1311 of the third conductive pattern 1310 may overlap the main portion BMLc of the lower metal layer BML, and the second portion 1312 of the third conductive pattern 1310 may overlap the first branch portion BMLa of the lower metal layer BML.

By arranging the third conductive pattern 1310 and the lower metal layer BML, which have the same voltage level, to overlap each other, coupling between the driving transistor T1 and peripheral components (wires or electrodes) may be prevented, and by efficiently arranging signal lines, voltage lines, and transistors of the first pixel circuit PC1, the second pixel circuit PC2, and the third pixel circuit PC3 in a limited space, space efficiency may be improved (e.g., a degree of integration may be improved). The third conductive pattern 1310 may include the opening 1310OP having a closed shape.

Each of the fourth conductive pattern 1320 and the fifth conductive pattern 1330 may be arranged in each of the first pixel circuit PC1, the second pixel circuit PC2, and the third pixel circuit PC3. Each of the fourth conductive pattern 1320 and the fifth conductive pattern 1330 may have an isolated shape.

The fourth conductive pattern 1320 may correspond to the lower compensation gate electrode G3a of the compensation transistor T3 described below, and the fifth conductive pattern 1330 may correspond to a lower first initialization gate electrode G4a of the first initialization transistor T4 described below.

The bridge pattern 1340 may be arranged in the separated space IVA between the second pixel circuit PC2 and the third pixel circuit PC3.

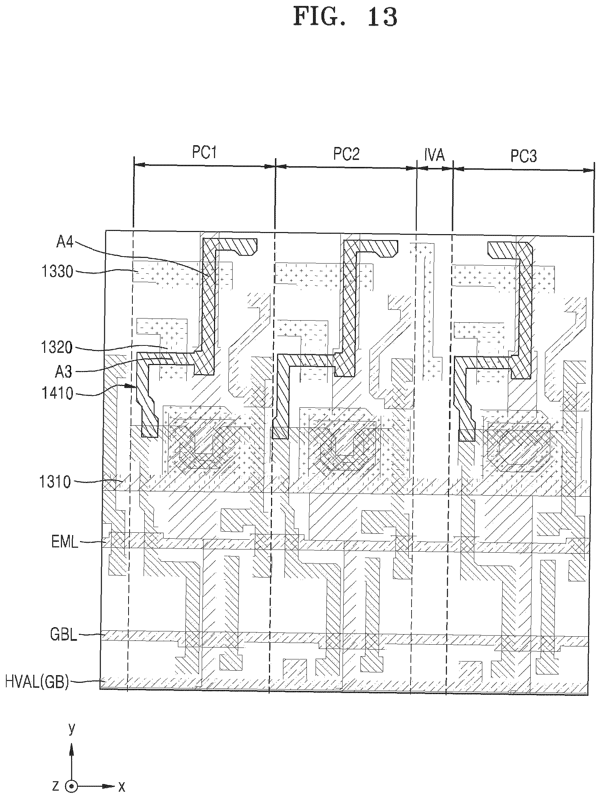

Referring to FIGS. 12 and 13, the first interlayer insulating layer 114 (see FIG. 4) may be disposed on the third conductive pattern 1310, the fourth conductive pattern 1320, the fifth conductive pattern 1330, and the bridge pattern 1340, and a second semiconductor layer may be disposed on the first interlayer insulating layer 114 (see FIG. 4). The second semiconductor layer may include the oxide semiconductor pattern 1410.

The oxide semiconductor pattern 1410 may have a bent shape. For example, the oxide semiconductor pattern 1410 may include a portion corresponding to the compensation semiconductor layer A3 and extending in the second direction (e.g., the ±x-axis direction) to overlap the fourth conductive pattern 1320, and a portion corresponding to a first initialization semiconductor layer A4 and extending in the first direction (e.g., the y-axis direction) to overlap the fifth conductive pattern 1330.

The oxide semiconductor pattern 1410 may include an oxide semiconductor material. For example, the oxide semiconductor pattern 1410 may include an oxide of at least one material selected from indium (In), gallium (Ga), tin (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn). For example, the oxide semiconductor pattern 1410 may include InSnZnO (ITZO), InGaZnO (IGZO), or the like. An oxide semiconductor has a wide band gap (about 3.1 eV), high carrier mobility, and a low leakage current, and thus, in the case that a driving time is long, a voltage drop is not large. Accordingly, a luminance change according to the voltage drop may not be large during a low frequency operation.

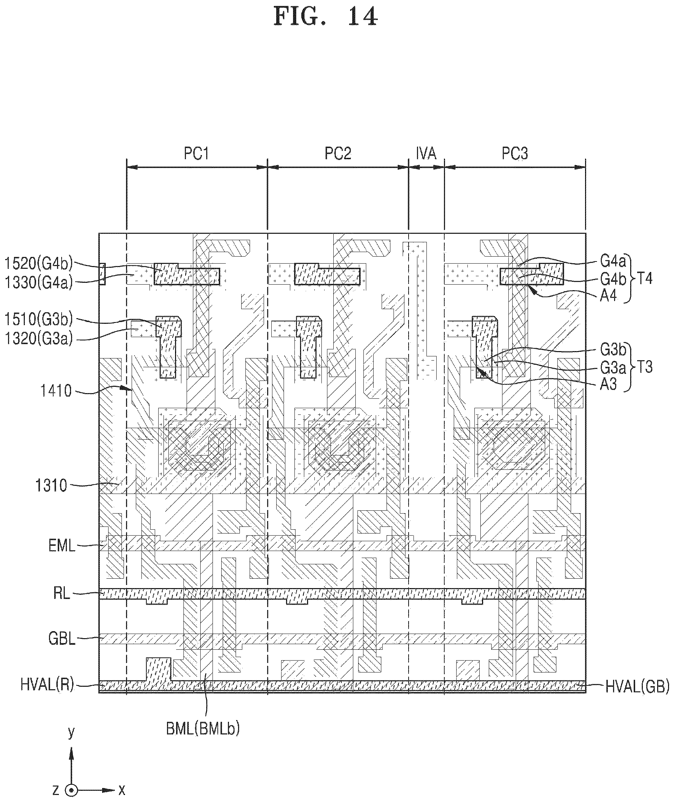

Referring to FIGS. 13 and 14, a third conductive layer may be disposed on the oxide semiconductor pattern 1410. The third conductive layer may include a sixth conductive pattern 1510, a seventh conductive pattern 1520, the repair line RL, and the second-first initialization horizontal voltage line HVAL(R).

The sixth conductive pattern 1510, the seventh conductive pattern 1520, the repair line RL, and the second-first initialization horizontal voltage line HVAL(R) may include the same material. The sixth conductive pattern 1510, the seventh conductive pattern 1520, the repair line RL, and the second-first initialization horizontal voltage line HVAL(R) may include Al, Pt, Pd, Ag, Mg, Au, Ni, Nd, Ir, Cr, Li, Ca, Mo, Ti, W, and/or Cu, and may be formed in a single layer or a multilayer including the above material. The sixth conductive pattern 1510, the seventh conductive pattern 1520, the repair line RL, and the second-first initialization horizontal voltage line HVAL(R) may have a three-layer structure of Al layer/Ti layer/Al layer.

Each of the sixth conductive pattern 1510 and the seventh conductive pattern 1520 may be arranged in each of the first pixel circuit PC1, the second pixel circuit PC2, and the third pixel circuit PC3. The sixth conductive pattern 1510 and the seventh conductive pattern 1520 may each have an isolated shape.

The sixth conductive pattern 1510 and the seventh conductive pattern 1520 may each overlap the oxide semiconductor pattern 1410 and include a gate electrode. The sixth conductive pattern 1510 may include a portion overlapping a portion of the oxide semiconductor pattern 1410, for example, the upper compensation gate electrode G3b overlapping the compensation semiconductor layer A3. The seventh conductive pattern 1520 may include a portion overlapping a portion of the oxide semiconductor pattern 1410, for example, an upper first initialization gate electrode G4b overlapping the first initialization semiconductor layer A4.

The compensation semiconductor layer A3 arranged in each of the first pixel circuit PC1, the second pixel circuit PC2, and the third pixel circuit PC3 may include a channel region overlapping the fourth conductive pattern 1320 disposed below the compensation semiconductor layer A3 and the sixth conductive pattern 1510 disposed on the compensation semiconductor layer A3, and a source region and a drain region arranged on sides (e.g., opposite sides) of the channel region. The first initialization semiconductor layer A4 arranged in each of the first pixel circuit PC1, the second pixel circuit PC2, and the third pixel circuit PC3 may include a channel region overlapping the fifth conductive pattern 1330 disposed below the first initialization semiconductor layer A4 and the seventh conductive pattern 1520 disposed on the first initialization semiconductor layer A4, and a source region and a drain region arranged on sides (e.g., opposite sides) of the channel region.

The fourth conductive pattern 1320 and the sixth conductive pattern 1510 may respectively correspond to the lower compensation gate electrode G3a and the upper compensation gate electrode G3b of the compensation transistor T3. The fifth conductive pattern 1330 and the seventh conductive pattern 1520 may respectively correspond to the lower first initialization gate electrode G4a and the upper first initialization gate electrode G4b of the first initialization transistor T4.

FIG. 14 illustrates the compensation transistor T3 including a double gate electrode of the lower compensation gate electrode G3a and the upper compensation gate electrode G3b, and the first initialization transistor T4 including a double gate electrode of the lower first initialization gate electrode G4a and the upper first initialization gate electrode G4b, but it is not limited thereto. The compensation transistor T3 may include one gate electrode from among the lower compensation gate electrode G3a and the upper compensation gate electrode G3b, and the first initialization transistor T4 may include one gate electrode from among the lower first initialization gate electrode G4a and the upper first initialization gate electrode G4b.

The second-first initialization horizontal voltage line HVAL(R) may be arranged on the same layer as the gate electrode (e.g., the sixth conductive pattern 1510 that is the upper compensation gate electrode G3b) of the compensation transistor T3, the gate electrode (e.g., the seventh conductive pattern 1520 that is the upper first initialization gate electrode G4b) of the first initialization transistor T4, and the repair line RL. For example, the second-first initialization horizontal voltage line HVAL(R), the sixth conductive pattern 1510, the seventh conductive pattern 1520, and the repair line RL may be disposed on third gate insulating layer 115 (see FIG. 4).

As described above with reference to FIG. 4, third gate insulating layer 115 (see FIG. 4) disposed below the sixth conductive pattern 1510, the seventh conductive pattern 1520, the repair line RL, and the second-first initialization horizontal voltage line HVAL(R) may be separated from each other, but are not limited thereto. The third gate insulating layer 115 (see FIG. 4) disposed below the sixth conductive pattern 1510, the seventh conductive pattern 1520, the repair line RL, and the second-first initialization horizontal voltage line HVAL(R) may be integral with each other.

The second-first initialization horizontal voltage line HVAL(R) and the second-second initialization horizontal voltage line HVAL(GB) may overlap each other. The second-second initialization horizontal voltage line HVAL(GB) and the second-first initialization horizontal voltage line HVAL(R) may have a voltage level of a constant voltage. For example, the second-second initialization horizontal voltage line HVAL(GB) and the second-first initialization horizontal voltage line HVAL(R) may have the same voltage level or a similar voltage level. The second-second initialization horizontal voltage line HVAL(GB) and the second-first initialization horizontal voltage line HVAL(R), which have the same or similar voltage level, are arranged to overlap each other, and thus, generation of parasitic capacitance between signal lines, voltage lines, and/or electrodes of transistors of the first pixel circuit PC1, the second pixel circuit PC2, and the third pixel circuit PC3 in a limited space is reduced and a space may be efficiently used (e.g., a degree of integration may be improved).

Each of the second-first initialization horizontal voltage line HVAL(R) and the second-second initialization horizontal voltage line HVAL(GB) may cross the second branch portion BMLb of the lower metal layer BML in a plan view, as shown in FIG. 14.

FIG. 14 illustrates the second-first initialization horizontal voltage line HVAL(R) arranged on the same layer and including the same material as the sixth conductive pattern 1510 that is the upper compensation gate electrode G3b of the compensation transistor T3 and/or the seventh conductive pattern 1520 that is the upper first initialization gate electrode G4b of the first initialization transistor T4, but the arrangement is not limited thereto. The second-first initialization horizontal voltage line HVAL(R) may be arranged on the same layer and include the same material as the fourth conductive pattern 1320 that is the lower compensation gate electrode G3a of the compensation transistor T3 and/or the fifth conductive pattern 1330 that is the lower first initialization gate electrode G4a of the first initialization transistor T4.

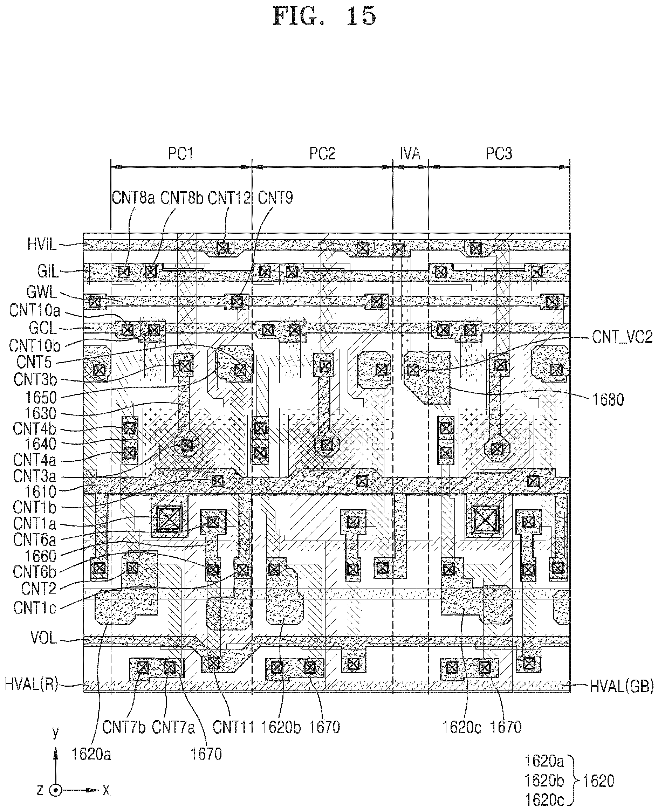

Referring to FIGS. 14 and 15, a second interlayer insulating layer 116 (see FIG. 4) , may be disposed on the sixth conductive pattern 1510, the seventh conductive pattern 1520, the repair line RL, and the second-first initialization horizontal voltage line HVAL(R), and a fourth conductive layer (or a connection conductive layer) may be disposed on the second interlayer insulating layer 116 (see FIG. 4). The fourth conductive layer may include a voltage delivery wire 1610, a first pixel connection electrode 1620, the first connection electrode 1630, a second connection electrode 1640, a third connection electrode 1650, a fourth connection electrode 1660, a fifth connection electrode 1670, a sixth connection electrode 1680, the first initialization horizontal voltage line HVIL, the first initialization control line GIL, the scan line GWL, the compensation scan line GCL, and the bias voltage line VOL. The voltage delivery wire 1610, the first pixel connection electrode 1620, the first connection electrode 1630, the second connection electrode 1640, the third connection electrode 1650, the fourth connection electrode 1660, the fifth connection electrode 1670, the sixth connection electrode 1680, the first initialization horizontal voltage line HVIL, the first initialization control line GIL, the scan line GWL, the compensation scan line GCL, and the bias voltage line VOL may be arranged on the same layer (e.g., the second interlayer insulating layer 116 in FIG. 4).

The voltage delivery wire 1610, the first pixel connection electrode 1620, the first connection electrode 1630, the second connection electrode 1640, the third connection electrode 1650, the fourth connection electrode 1660, the fifth connection electrode 1670, the sixth connection electrode 1680, the first initialization horizontal voltage line HVIL, the first initialization control line GIL, the scan line GWL, the compensation scan line GCL, and the bias voltage line VOL may include the same material. The voltage delivery wire 1610, the first pixel connection electrode 1620, the first connection electrode 1630, the second connection electrode 1640, the third connection electrode 1650, the fourth connection electrode 1660, the fifth connection electrode 1670, the sixth connection electrode 1680, the first initialization horizontal voltage line HVIL, the first initialization control line GIL, the scan line GWL, the compensation scan line GCL, and the bias voltage line VOL may include at least one material selected from Al, Pt, Pd, Ag, Mg, Au, Ni, Nd, Ir, Cr, Li, Ca, Mo, Ti, W, and Cu.

The voltage delivery wire 1610 may extend in the second direction (e.g., the x-axis direction). The voltage delivery wire 1610 may pass through each of the first pixel circuit PC1, the second pixel circuit PC2, and the third pixel circuit PC3.

The voltage delivery wire 1610 may have a voltage level of the driving voltage ELVDD (see FIG. 3).The voltage delivery wire 1610 may have the voltage level of the driving voltage ELVDD (see FIG. 3) by being electrically connected to the driving voltage line PL described below.

The voltage delivery wire 1610 may be electrically connected to the lower metal layer BML (see FIG. 9) through a first-first contact hole CNT1a. The voltage delivery wire 1610 may be electrically connected to the third conductive pattern 1310 (see FIG. 14) through a first-second contact hole CNT1b. The voltage delivery wire 1610 may be electrically connected to the first silicon semiconductor pattern 1110 (see FIG. 10) through a first-third contact hole CNT1c. The lower metal layer BML (see FIG. 9) may have the voltage level of the driving voltage ELVDD through a connection structure of the voltage delivery wire 1610 and the lower metal layer BML (see FIG. 9) through the first-first contact hole CNT1a. The voltage delivery wire 1610 may provide the driving voltage ELVDD to the upper electrode CE2 (see FIG. 12) of the first capacitor Cst and the operation control semiconductor layer A5 (see FIG. 10) of the operation control transistor T5 through the first-second contact hole CNT1b and the first-third contact hole CNT1c.

The first pixel connection electrode 1620 may be spaced apart from the voltage delivery wire 1610. The first pixel connection electrode 1620 may be electrically insulated from the voltage delivery wire 1610.

The first pixel connection electrode 1620 may be arranged on the same layer as the voltage delivery wire 1610. The first pixel connection electrode 1620 may include a first-first pixel connection electrode 1620a, a first-second pixel connection electrode 1620b, and a first-third pixel connection electrode 1620c, which are respectively arranged in the first pixel circuit PC1, the second pixel circuit PC2, and the third pixel circuit PC3. Each of the first-first pixel connection electrode 1620a, the first-second pixel connection electrode 1620b, and the first-third pixel connection electrode 1620c may be spaced apart from the voltage delivery wire 1610.

The first pixel connection electrode 1620 may be electrically connected to the first silicon semiconductor pattern 1110 through a second contact hole CNT2. For example, the first-first pixel connection electrode 1620a may be electrically connected to the first silicon semiconductor pattern 1110 (see FIG. 11) corresponding to the first pixel circuit PC1, through the second contact hole CNT2. The first pixel connection electrode 1620 may be electrically connected to the emission control semiconductor layer A6 (see FIG. 11) of the emission control transistor T6 (see FIG. 11) and/or the second initialization semiconductor layer A7 (see FIG. 11) of the second initialization transistor T7 formed along the first silicon semiconductor pattern 1110.

The first connection electrode 1630, the second connection electrode 1640, the third connection electrode 1650, the fourth connection electrode 1660, and the fifth connection electrode 1670 may each have an isolated shape. Each of the first connection electrode 1630, the second connection electrode 1640, the third connection electrode 1650, the fourth connection electrode 1660, and the fifth connection electrode 1670 may be arranged in each of the first pixel circuit PC1, the second pixel circuit PC2, and the third pixel circuit PC3.

The first connection electrode 1630 may electrically connect the first conductive pattern 1210 (see FIG. 11) to the oxide semiconductor pattern 1410 (see FIG. 13). The first connection electrode 1630 may be electrically connected to the first conductive pattern 1210 (see FIG. 11) through a third-first contact hole CNT3a. The first connection electrode 1630 may be electrically connected to the oxide semiconductor pattern 1410 (e.g., the compensation semiconductor layer A3 of the compensation transistor T3) (see FIG. 13) through a third-second contact hole CNT3b. The first connection electrode 1630 may electrically connect the driving gate electrode G1 (see FIG. 11) of the driving transistor T1 to the compensation semiconductor layer A3 (see FIG. 13) of the compensation transistor T3. The first connection electrode 1630 may electrically connect the first capacitor Cst to the compensation transistor T3.

The first connection electrode 1630 may overlap a portion of the lower metal layer BML (see FIG. 9), for example, the second branch portion BMLb.

The second connection electrode 1640 may electrically connect the first silicon semiconductor pattern 1110 (see FIG. 11) to the oxide semiconductor pattern 1410 (see FIG. 14). The second connection electrode 1640 may be electrically connected to the first silicon semiconductor pattern 1110 (see FIG. 11) through a fourth-first contact hole CNT4a. The second connection electrode 1640 may be electrically connected to the oxide semiconductor pattern 1410 (see FIG. 14) through a fourth-second contact hole CNT4b. The second connection electrode 1640 may electrically connect the driving semiconductor layer A1 (see FIG. 11) of the driving transistor T1 to the compensation semiconductor layer A3 (see FIG. 14) of the compensation transistor T3. The second connection electrode 1640 may electrically connect the emission control semiconductor layer A6 (see FIG. 11) of the emission control transistor T6 to the compensation semiconductor layer A3 (see FIG. 14) of the compensation transistor T3.

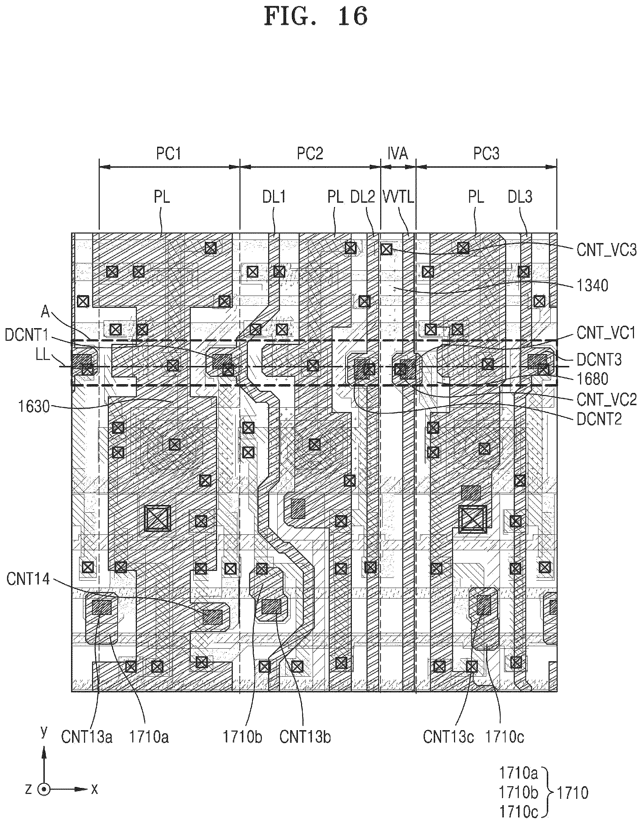

The third connection electrode 1650 may be electrically connected to the first silicon semiconductor pattern 1110 (see FIG. 11) through a fifth contact hole CNT5. For example, the third connection electrode 1650 corresponding to the first pixel circuit PC1 may be electrically connected to the first data line DL1 described below with reference to FIG. 16. For example, the third connection electrode 1650 corresponding to the first pixel circuit PC1 may transmit a data signal applied to the first data line DL1 to the data write semiconductor layer A2 (see FIG. 11) of the data write transistor T2. For example, the third connection electrode 1650 corresponding to the second pixel circuit PC2 may be electrically connected to the second data line DL2 described below with reference to FIG. 16. For example, the third connection electrode 1650 corresponding to the third pixel circuit PC3 may be electrically connected to the third data line DL3 described below with reference to FIG. 16. The third connection electrode 1650 may correspond to the data connection pattern DCP described with reference to FIGS. 6 and 7. For example, the third connection electrode 1650 electrically connected to the first data line DL1 may be referred to as a first data connection pattern, the third connection electrode 1650 electrically connected to the second data line DL2 may be referred to as a second data connection pattern, and the third connection electrode 1650 electrically connected to the third data line DL3 may be referred to as a third data connection pattern.

The fourth connection electrode 1660 may electrically connect the first silicon semiconductor pattern 1110 (see FIG. 11) to the second silicon semiconductor pattern 1120 (see FIG. 11). The fourth connection electrode 1660 may be electrically connected to the first silicon semiconductor pattern 1110 (see FIG. 11) through a sixth-first contact hole CNT6a. The fourth connection electrode 1660 may be electrically connected to the second silicon semiconductor pattern 1120 (see FIG. 11) through a sixth-second contact hole CNT6b. The fourth connection electrode 1660 may electrically connect the operation control semiconductor layer A5 (see FIG. 11) of the operation control transistor T5 formed along the first silicon semiconductor pattern 1110 (see FIG. 11) to the bias semiconductor layer A8 (see FIG. 11) of the bias transistor T8 formed along the second silicon semiconductor pattern 1120 (see FIG. 11).

The fifth connection electrode 1670 corresponding to the first pixel circuit PC1 may electrically connect the first silicon semiconductor pattern 1110 (see FIG. 11) corresponding to the first pixel circuit PC1 to the second-first initialization horizontal voltage line HVAL(R). The fifth connection electrode 1670 corresponding to the first pixel circuit PC1 may electrically connect the second initialization semiconductor layer A7 (see FIG. 11) of the second initialization transistor T7 formed along the first silicon semiconductor pattern 1110 (see FIG. 11) to the second-first initialization horizontal voltage line HVAL(R).

The fifth connection electrode 1670 corresponding to the first pixel circuit PC1 may be electrically connected to the second initialization semiconductor layer A7 (see FIG. 11) of the second initialization transistor T7 corresponding to the first pixel circuit PC1 through a seventh-first contact hole CNT7a, and electrically connected to the second-first initialization horizontal voltage line HVAL(R) through a seventh-second contact hole CNT7b. The second-first initialization horizontal voltage line HVAL(R) may transmit the second-first initialization voltage to the second initialization transistor T7 of the first pixel circuit PC1 through the fifth connection electrode 1670.

The fifth connection electrode 1670 corresponding to each of the second pixel circuit PC2 and the third pixel circuit PC3 may electrically connect the first silicon semiconductor pattern 1110 (see FIG. 11) corresponding to each of the second pixel circuit PC2 and the third pixel circuit PC3 to the second-second initialization horizontal voltage line HVAL(GB). The fifth connection electrode 1670 corresponding to each of the second pixel circuit PC2 and the third pixel circuit PC3 may electrically connect the second initialization semiconductor layer A7 (see FIG. 11) of the second initialization transistor T7 corresponding to each of the second pixel circuit PC2 and the third pixel circuit PC3 to the second-second initialization horizontal voltage line HVAL(GB).

The fifth connection electrode 1670 corresponding to each of the second pixel circuit PC2 and the third pixel circuit PC3 may be electrically connected to the second initialization semiconductor layer A7 (see FIG. 9) of the second initialization transistor T7 corresponding to each of the second pixel circuit PC2 and the third pixel circuit PC3, through the seventh-first contact hole CNT7a. The fifth connection electrode 1670 corresponding to each of the second pixel circuit PC2 and the third pixel circuit PC3 may be electrically connected to the second-second initialization horizontal voltage line HVAL(GB) through the seventh-second contact hole CNT7b. The second-second initialization horizontal voltage line HVAL(GB) may transmit the second-second initialization voltage to the second initialization transistor T7 (see FIG. 11) corresponding to each of the second pixel circuit PC2 and the third pixel circuit PC3, through the fifth connection electrode 1670 arranged in each of the second pixel circuit PC2 and the third pixel circuit PC3. The second-first initialization voltage and the second-second initialization voltage may have the same voltage level.

The sixth connection electrode 1680 may have an isolated shape. At least a portion of the sixth connection electrode 1680 may be arranged in the separated space IVA where the vertical voltage line VVTL (see FIG. 8) is arranged. The sixth connection electrode 1680 may correspond to the voltage connection pattern VCP described with reference to FIGS. 6 and 7. The sixth connection electrode 1680 may be electrically connected to the vertical voltage line VVTL (see FIG. 8).The sixth connection electrode 1680 may be electrically connected to the bridge pattern 1340 (see FIG. 12) through a contact hole CNT_VC2.

The first initialization control line GIL, the scan line GWL, the compensation scan line GCL, the bias voltage line VOL, and the first initialization horizontal voltage line HVIL may each extend in the second direction (e.g., the ±x-axis direction).

The first initialization control line GIL may be electrically connected to the fifth conductive pattern 1330 (see FIG. 14) and the seventh conductive pattern 1520 (see FIG. 14) of each of the first pixel circuit PC1, the second pixel circuit PC2, and the third pixel circuit PC3. The first initialization control line GIL may be electrically connected to the fifth conductive pattern 1330 (see FIG. 14) of each of the first pixel circuit PC1, the second pixel circuit PC2, and the third pixel circuit PC3 through an eighth-first contact hole CNT8a. The first initialization control line GIL may be electrically connected to the seventh conductive pattern 1520 (see FIG. 14) of each of the first pixel circuit PC1, the second pixel circuit PC2, and the third pixel circuit PC3 through an eighth-second contact hole CNT8b. The first initialization control line GIL may provide the first initialization control signal GI (see FIG. 3) to each of the fifth conductive pattern 1330 (see FIG. 14) that is the lower first initialization gate electrode G4a of the first initialization transistor T4 and the seventh conductive pattern 1520 (see FIG. 14) that is the upper first initialization gate electrode G4b.

The scan line GWL may be electrically connected to the second conductive pattern 1220 (see FIG. 11) of each of the first pixel circuit PC1, the second pixel circuit PC2, and the third pixel circuit PC3 through a ninth contact hole CNT9. The scan line GWL may provide the scan signal GW (see FIG. 3) to the second conductive pattern 1220 (see FIG. 11) that is the second gate electrode G2 (see FIG. 11) of the data write transistor T2 of each of the first pixel circuit PC1, the second pixel circuit PC2, and the third pixel circuit PC3.

The compensation scan line GCL may be electrically connected to the fourth conductive pattern 1320 (see FIG. 14) and the sixth conductive pattern 1510 (see FIG. 14) of each of the first pixel circuit PC1, the second pixel circuit PC2, and the third pixel circuit PC3. The compensation scan line GCL may be electrically connected to the fourth conductive pattern 1320 (see FIG. 14) of each of the first pixel circuit PC1, the second pixel circuit PC2, and the third pixel circuit PC3 through a tenth-first contact hole CNT10a. The compensation scan line GCL may be electrically connected to the sixth conductive pattern 1510 (see FIG. 14) of each of the first pixel circuit PC1, the second pixel circuit PC2, and the third pixel circuit PC3 through a tenth-second contact hole CNT10b. The compensation scan line GCL may provide the compensation scan signal GC (see FIG. 3) to each of the fourth conductive pattern 1320 (see FIG. 12) that is the lower compensation gate electrode G3a of the compensation transistor T3 and the sixth conductive pattern 1510 that is the upper compensation gate electrode G3b.

The bias voltage line VOL may be electrically connected to the second silicon semiconductor pattern 1120 (see FIG. 11) of each of the first pixel circuit PC1, the second pixel circuit PC2, and the third pixel circuit PC3 through an eleventh contact hole CNT11. The bias voltage line VOL may provide the bias voltage Vobs (see FIG. 3) to the bias semiconductor layer A8 (see FIG. 11) of the bias transistor T8 of each of the first pixel circuit PC1, the second pixel circuit PC2, and the third pixel circuit PC3.

The first initialization horizontal voltage line HVIL may be electrically connected to the oxide semiconductor pattern 1410 (see FIG. 13) of each of the first pixel circuit PC1, the second pixel circuit PC2, and the third pixel circuit PC3 through a twelfth contact hole CNT12. For example, the first initialization voltage Vint (see FIG. 3) may be provided to the first initialization semiconductor layer A4 (see FIG. 14) of the first initialization transistor T4 formed along the oxide semiconductor pattern 1410 (see FIG. 13).

Referring to FIGS. 15 and 16, the first via insulating layer 121 (see FIG. 4) may be disposed on the voltage delivery wire 1610, the first pixel connection electrode 1620, the first connection electrode 1630, the second connection electrode 1640, the third connection electrode 1650, the fourth connection electrode 1660, the fifth connection electrode 1670, the sixth connection electrode 1680, the first initialization horizontal voltage line HVIL, the first initialization control line GIL, the scan line GWL, the compensation scan line GCL, and the bias voltage line VOL, and a fifth conductive layer (or a vertical conductive layer) may be disposed on the first via insulating layer 121 (see FIG. 4). The fifth conductive layer may include a second pixel connection electrode 1710, the driving voltage line PL, the first data line DL1, the second data line DL2, the third data line DL3, and the vertical voltage line VVTL. The second pixel connection electrode 1710, the driving voltage line PL, the first data line DL1, the second data line DL2, the third data line DL3, and the vertical voltage line VVTL may be arranged on the same layer (e.g., the first via insulating layer 121).

The driving voltage line PL, the first data line DL1, the second data line DL2, the third data line DL3, and the vertical voltage line VVTL may extend in the first direction (e.g., the ±y-axis direction). The driving voltage line PL, the first data line DL1, the second data line DL2, the third data line DL3, the vertical voltage line VVTL, and the second pixel connection electrode 1710 may include the same material.

The driving voltage line PL, the first data line DL1, the second data line DL2, the third data line DL3, the vertical voltage line VVTL, and the second pixel connection electrode 1710 may include at least one material selected from Al, Pt, Pd, Ag, Mg, Au, Ni, Nd, Ir, Cr, Li, Ca, Mo, Ti, W, and Cu.

The driving voltage line PL may be arranged in each of the first pixel circuit PC1, the second pixel circuit PC2, and the third pixel circuit PC3. The driving voltage line PL corresponding to any one of the first pixel circuit PC1, the second pixel circuit PC2, and the third pixel circuit PC3 may be electrically connected to the voltage delivery wire 1610 (see FIG. 15) through a fourteenth contact hole CNT14. Shapes and areas of the driving voltage lines PL arranged in the first pixel circuit PC1, the second pixel circuit PC2, and the third pixel circuit PC3 may be different from each other.

The driving voltage line PL arranged in each of the first pixel circuit PC1, the second pixel circuit PC2, and the third pixel circuit PC3 may overlap the gate electrode, for example, the lower compensation gate electrode G3a and the upper compensation gate electrode G3b of FIG. 14, of the compensation transistor T3 of each of the first pixel circuit PC1, the second pixel circuit PC2, and the third pixel circuit PC3, and overlap the first connection electrode 1630 corresponding to each of the first pixel circuit PC1, the second pixel circuit PC2, and the third pixel circuit PC3. For example, the first connection electrode 1630 may connect the compensation semiconductor layer A3 of the compensation transistor T3 to the driving gate electrode G1 of the driving transistor T1. Through such an overlapping structure, unnecessary parasitic capacitance may be prevented from affecting the compensation transistor T3 and the first connection electrode 1630. In a plan view shown in FIG. 16, the first connection electrode 1630 overlaps the driving voltage line PL and the second branch portion BMLb of the lower metal layer BML (see FIG. 9) having the same voltage level (e.g., a level of the driving voltage ELVDD) of a constant voltage, and thus, generation of the parasitic capacitance may be further effectively prevented.

The first data line DL1, the second data line DL2, and the third data line DL3 may be electrically connected to the data write transistors T2 (see FIG. 11) of the first pixel circuit PC1, the second pixel circuit PC2, and the third pixel circuit PC3, respectively. The first data line DL1, the second data line DL2, and the third data line DL3 may transmit the data signal Dm (see FIG. 3) respectively to the first pixel circuit PC1, the second pixel circuit PC2, and the third pixel circuit PC3.

The first data line DL1 may be electrically connected to the third connection electrode 1650 (see FIG. 15) corresponding to the first pixel circuit PC1, through a first data contact hole DCNT1. For example, the second data line DL2 may be electrically connected to the third connection electrode 1650 corresponding to the second pixel circuit PC2 through a second data contact hole DCNT2, and the third data line DL3 may be electrically connected to the third connection electrode 1650 corresponding to the third pixel circuit PC3 through a third data contact hole DCNT3. The third connection electrode 1650 corresponding to each of the first pixel circuit PC1, the second pixel circuit PC2, and the third pixel circuit PC3 may be electrically connected to the first silicon semiconductor pattern 1110 (see FIG. 10) of a corresponding pixel circuit, and thus, the data signal Dm (see FIG. 3) may be provided to the data write semiconductor layer A2 (see FIG. 11) of the data write transistor T2 formed along the first silicon semiconductor pattern 1110 (see FIG. 10).

Shapes of the first data line DL1, the second data line DL2, and the third data line DL3 may be different from each other in a plan view. For example, the first data line DL1 and the second data line DL2 may include regions corresponding to the second pixel circuit PC2 while having different plane shapes. For example, the first data line DL1 and the second data line DL2 may be asymmetric based on a virtual line extending along the first direction (e.g., the ±y-axis direction) between the first data line DL1 and the second data line DL2. The plane shape of the third data line DL3 may be different from the plane shape of each of the first data line DL1 and the second data line DL2.

Each of the first data line DL1, the second data line DL2, and the third data line DL3 may cross the second-first initialization horizontal voltage line HVAL(R) and the second-second initialization horizontal voltage line HVAL(GB) in a plan view.

The vertical voltage line VVTL may be arranged in the separated space IVA between the second pixel circuit PC2 and the third pixel circuit PC3. For example, the vertical voltage line VVTL may be located between the driving voltage lines PL of the second data line DL2 and third pixel circuit PC3.

The vertical voltage line VVTL may be electrically connected to a voltage line extending in the second direction (e.g., the ±x-axis direction). FIG. 16 illustrates the vertical voltage line VVTL being connected to the sixth connection electrode 1680 through a contact hole CNT_VC1, the sixth connection electrode 1680 being connected to the bridge pattern 1340 disposed immediately therebelow through the contact hole CNT_VC2, and the bridge pattern 1340 being electrically connected to the first initialization horizontal voltage line HVIL through a contact hole CNT_VC3. For example, the vertical voltage line VVTL illustrated in FIG. 16 may be the first initialization vertical voltage line VVIL (see FIG. 5).

The second pixel connection electrode 1710 may be electrically connected to the first pixel connection electrode 1620 (see FIG. 15). For example, a second-first pixel connection electrode 1710a may be electrically connected to the first-first pixel connection electrode 1620a (see FIG. 15) through a thirteenth-first contact hole CNT13a. For example, a second-second pixel connection electrode 1710b may be electrically connected to the first-second pixel connection electrode 1620b (see FIG. 15) through a thirteenth-second contact hole CNT13b. For example, a second-third pixel connection electrode 1710c may be electrically connected to the first-third pixel connection electrode 1620c (see FIG. 15) through a thirteenth-third contact hole CNT13c.

As shown in region A, in a plan view, the first data contact hole DCNT1, the second data contact hole DCNT2, and the third data contact hole DCNT3 may be arranged in a row in the second direction (e.g., the ±x-axis direction). For example, in a plan view, the first data contact hole DCNT1, the second data contact hole DCNT2, and the third data contact hole DCNT3 may be arranged in a row in the second direction (e.g., the ±x-axis direction) together with the contact hole CNT_VC1 electrically connecting the vertical voltage line VVTL to the sixth connection electrode 1680. For example, the first data contact hole DCNT1, the second data contact hole DCNT2, the third data contact hole DCNT3, and the contact hole CNT_VC1 electrically connecting the vertical voltage line VVTL to the sixth connection electrode 1680 may be arranged on a virtual straight line LL extending in the second direction (e.g., the ±x-axis direction).

Referring to FIGS. 16 and 17, the second via insulating layer 123 (see FIG. 4) may be disposed on the second pixel connection electrode 1710, the driving voltage line PL, the first data line DL1, the second data line DL2, the third data line DL3, and the vertical voltage line VVTL, and the first pixel electrode 210a, the second pixel electrode 210b, and the third pixel electrode 210c may be disposed on the second via insulating layer 123 (see FIG. 4).

The first pixel electrode 210a electrically connected to the first pixel circuit PC1, the second pixel electrode 210b electrically connected to the second pixel circuit PC2, and the third pixel electrode 210c electrically connected to the third pixel circuit PC3 may be spaced apart from each other. The first pixel electrode 210a and the second pixel electrode 210b may be arranged on the same column in the first direction (e.g., the y-axis direction) and may be alternately arranged. The third pixel electrodes 210c may be arranged in a column adjacent to the column where the first pixel electrode 210a and the second pixel electrode 210b are arranged.

The first pixel electrode 210a, the second pixel electrode 210b, and the third pixel electrode 210c may be electrically connected to the first pixel circuit PC1, the second pixel circuit PC2, and the third pixel circuit PC3 respectively through the second pixel connection electrode 1710 (see FIG. 16) and the first pixel connection electrode 1620 (see FIG. 15). The first pixel electrode 210a may be connected to the second-first pixel connection electrode 1710a (see FIG. 16) through a sixteenth-first contact hole CNT16a, and the second-first pixel connection electrode 1710a may be electrically connected to the first-first pixel connection electrode 1620a (see FIG. 15) through the thirteenth-first contact hole CNT13a . The second pixel electrode 210b may be connected to the second-second pixel connection electrode 1710b (see FIG. 16) through a sixteenth-second contact hole CNT16b, and the second-second pixel connection electrode 1710b may be electrically connected to the first-second pixel connection electrode 1620b (see FIG. 15) through a thirteenth-second contact hole CNT13b . The third pixel electrode 210c may be connected to the second-third pixel connection electrode 1710c (see FIG. 16) through a sixteenth-third contact hole CNT16c, and the second-third pixel connection electrode 1710c may be electrically connected to the first-third pixel connection electrode 1620c (see FIG. 15) through the thirteenth-third contact hole CNT13c .

Referring to FIGS. 17 and 18, the bank layer 130 may be disposed on the first pixel electrode 210a, the second pixel electrode 210b, and the third pixel electrode 210c. Portions of the first pixel electrode 210a, the second pixel electrode 210b, and the third pixel electrode 210c may be exposed by the pixel opening 130OP defined in the bank layer 130. For example, the bank layer 130 may include a first pixel opening 130OP1 that covers an edge portion of the first pixel electrode 210a and exposes a portion of the first pixel electrode 210a. For example, the bank layer 130 may include a second pixel opening 130OP2 that covers an edge portion of the second pixel electrode 210b and exposes a portion of the second pixel electrode 210b. For example, the bank layer 130 may include a third pixel opening 130OP3 that covers an edge portion of the third pixel electrode 210c and exposes a portion of the third pixel electrode 210c. The first pixel opening 130OP1, the second pixel opening 130OP2, and the third pixel opening 130OP3 may respectively define the first emission area EA1 of the first light-emitting diode, the second emission area EA2 of the second light-emitting diode, and the third emission area EA3 of the third light-emitting diode.

The bank layer 130 may increase a distance between the edge portion of the first pixel electrode 210a and the opposing electrode 230 (see FIG. 4), a distance between the edge portion of the second pixel electrode 210b and the opposing electrode 230 (see FIG. 4), and a distance between the third pixel electrode 210c and the opposing electrode 230 (see FIG. 4), thereby preventing arc or the like from being generated at the edge portion of each of the first pixel electrode 210a, the second pixel electrode 210b, and the third pixel electrode 210c.

As shown in FIGS. 8 and 18, the second data contact hole DCNT2 and the contact hole CNT_VC1 electrically connecting the vertical voltage line VVTL to the sixth connection electrode 1680 (see FIG. 15) may be located between the third emission areas EA3 adjacent to each other, and the first data contact hole DCNT1, the second data contact hole DCNT2, the third data contact hole DCNT3, and the contact hole CNT_VC1 electrically connecting the vertical voltage line VVTL to the sixth connection electrode 1680 (see FIG. 15) may be arranged in a row in the second direction (e.g., the ±x-axis direction). For example, the first data contact hole DCNT1, the second data contact hole DCNT2, the third data contact hole DCNT3, and the contact hole CNT_VC1 electrically connecting the vertical voltage line VVTL to the sixth connection electrode 1680 (see FIG. 15) may be located between the third emission areas EA3 adjacent to each other, and may be arranged on the virtual straight line LL extending in the second direction (e.g., the x-axis direction).

Referring to FIGS. 16 and 18 together, in a plan view, the thirteenth-first contact hole CNT13a that connects the second-first pixel connection electrode 1710a to the first-first pixel connection electrode 1620a (see FIG. 15) and penetrates the first via insulating layer 121 (see FIG. 4) may be spaced apart from the pixel opening 130OP (e.g., an emission area EA). For example, the thirteenth-second contact hole CNT13b and the thirteenth-third contact hole CNT13c may be spaced apart from the pixel opening 130OP (e.g., the emission area EA) in a plan view. For example, the fourteenth contact hole CNT14 that connects the driving voltage line PL to the voltage delivery wire 1610 (see FIG. 15) and penetrates the first via insulating layer 121 (see FIG. 4) may be spaced apart from the pixel opening 130OP (e.g., the emission area EA).

In a plan view, contact holes penetrating the first via insulating layer 121 may be spaced apart from the emission area.

Hereinafter, redundant descriptions on components using same reference numerals as those described above will be omitted.

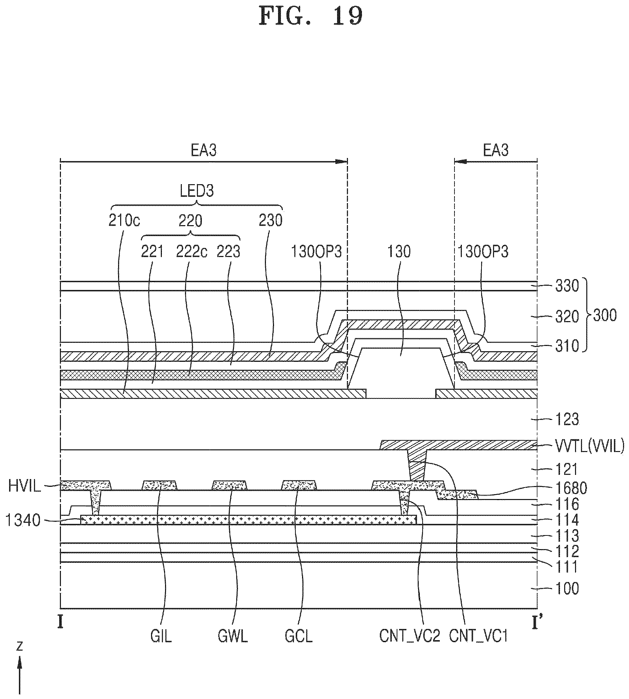

FIG. 19 is a schematic cross-sectional view of the display device 1 taken along line I-I' of FIG. 18.

Referring to FIGS. 8 to 19, a contact hole may connect the vertical voltage line VVTL arranged on a layer most adjacent to the first pixel electrode 210a, the second pixel electrode 210b, and the third pixel electrode 210c in a direction facing a top surface of the substrate 100 (e.g., the -z-axis direction) to the connection conductive pattern CP (see FIG. 6) disposed below the vertical voltage line VVTL, and the contact hole penetrating the first via insulating layer 121 may overlap the bank layer 130 and may not overlap the pixel opening 130OP (or the emission area EA) of the bank layer 130.

As shown in FIG. 19, the first initialization vertical voltage line VVIL that is the vertical voltage line VVTL arranged on a layer most adjacent to the third pixel electrode 210c in the direction facing the top surface of the substrate 100 may be connected to the sixth connection electrode 1680 corresponding to the connection conductive pattern CP (see FIG. 6) through the contact hole CNT_VC1 penetrating the first via insulating layer 121, and the contact hole CNT_VC1 may overlap the bank layer 130 and may not overlap the third pixel opening 130OP3 (or the third emission area EA3). For example, in a plan view, the contact hole CNT_VC1 may be spaced apart from the third emission area EA3.

FIG. 19 illustrates the first initialization vertical voltage line VVIL from among the vertical voltage lines VVTL, but the second-first initialization vertical voltage line VVAL(R), the second-second initialization vertical voltage line VVAL(GB), and the common voltage line VSL may each be connected to the connection conductive pattern CP (see FIG. 6) through a contact hole penetrating the first via insulating layer 121, and the contact hole penetrating the first via insulating layer 121 may overlap the bank layer 130 and may not overlap the pixel opening 130OP (or the emission area EA).

The emission area EA (see FIG. 4) of the light-emitting diode LED (see FIG. 4) may not overlap contact holes penetrating the first via insulating layer 121, and thus, the second via insulating layer 123 may not be curved in a region where the pixel opening 130OP overlaps and may provide a substantially flat top surface. Accordingly, the first pixel electrode 210a, the second pixel electrode 210b, and the third pixel electrode 210c disposed on the second via insulating layer 123 may be formed substantially flat, and thus, color deviation or image quality deviation caused by a viewing angle of the display device 1 (see FIG. 1) may be reduced or prevented.

The vertical voltage line VVTL arranged on a layer most adjacent to the first pixel electrode 210a, the second pixel electrode 210b, and the third pixel electrode 210c in the direction (e.g., the -z-axis direction) facing the top surface of the substrate 100 may be disposed on the first via insulating layer 121, and thus, through holes penetrating the first via insulating layer 121 may not overlap the emission area EA (see FIG. 4), but the arrangement is not limited thereto. In the case that the display device 1 (see FIG. 1) further includes a sixth conductive layer on the second via insulating layer 123 and a third via insulating layer on the sixth conductive layer, and the first pixel electrode 210a, the second pixel electrode 210b, and the third pixel electrode 210c are disposed on the third via insulating layer, conductive patterns of the sixth conductive layer may be electrically connected to a conductive layer disposed below the sixth conductive layer and a contact hole penetrating the second via insulating layer 123 may not overlap the emission areas EA (see FIG. 4) like a contact hole penetrating the first via insulating layer 121, described in the disclosure.

FIGS. 20A and 20B are cross-sectional views of the display device 1 taken along line II-II' of FIG. 18. FIGS. 20A and 20B illustrate the separator SEP according to different implementations.

Referring to FIGS. 18 and 20A, the bank layer 130 may define auxiliary openings OPs surrounding a portion of the first pixel opening 130OP1, a portion of the second pixel opening 130OP2, and a portion of the pair of adjacent third pixel openings 130OP3, and for example, the auxiliary opening OPs may function as the separator SEP. The auxiliary openings OPs may be spaced apart from the first pixel opening 130OP1, the second pixel opening 130OP2, and the third pixel opening 130OP3. As shown in FIG. 20A, a side surface of the auxiliary opening OPs may have a reverse tapered shape. For example, a side surface of the bank layer 130 defining the auxiliary opening OPs may have an undercut structure.

Common layers, e.g., the first functional layer 221, the second functional layer 223, and the opposing electrode 230, formed integrally in response to the light-emitting diodes LED (see FIG. 4) may include discontinuous portions that are cut by the separators SEP or have low thicknesses compared to surrounding areas. For example, the first functional layer 221, the second functional layer 223, and the opposing electrode 230, which are disposed on a top surface of the bank layer 130, may be separated and spaced apart from a dummy layer dm arranged in the auxiliary opening OPs. However, the separators SEP may not surround (e.g., completely surround) the first pixel opening 130OP1, the second pixel opening 130OP2, and the third pixel opening 130OP3, and thus, the opposing electrodes 230 may be integrated by being connected to each other in the display area DA (see FIG. 1).

Referring to FIGS. 18 and 20B, the separator SEP may be disposed on the bank layer 130. The separator SEP may include the same material as the bank layer 130, but is not limited thereto. The separator SEP may include a different material from the bank layer 130. The separator SEP may have a reverse tapered shape. The separators SEP may include a separator surrounding a portion of the first pixel opening 130OP1, a separator surrounding a portion of the second pixel opening 130OP2, and a separator surrounding a portion of the pair of adjacent third pixel openings 130OP3. The dummy layer dm that is formed as the first functional layer 221, the second functional layer 223, and the opposing electrode 230 are separated may be provided between the separators SEP surrounding adjacent pixel openings. The dummy layer dm may be disposed on a top surface of the separator SEP.

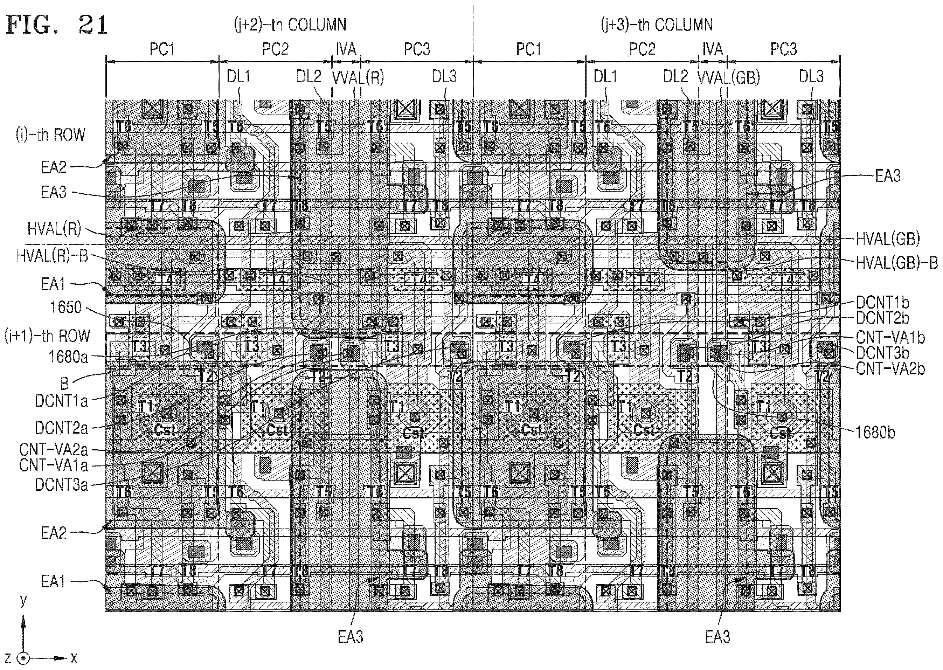

FIG. 21 is a schematic plan view showing a portion of electrical connections of four adjacent pixels. FIG. 21 illustrates the portion of the electrical connections of the four pixels arranged in an i-th row, an (i+1)-th row, a (j+2)-th column, and a (j+3)-th column. FIG. 21 illustrates an electrical connection between the second-first initialization horizontal voltage line HVAL(R) and the second-first initialization vertical voltage line VVAL(R), and an electrical connection between the second-second initialization horizontal voltage line HVAL(GB) and the second-second initialization vertical voltage line VVAL(GB) of the display device 1.

Referring to FIG. 21, a distance between the third emission areas EA3 adjacent to each other in the (j+2)-th column in the first direction may be less than a distance between the third emission areas EA3 adjacent to each other in the (j+3)-th column that is a column adjacent to the (j+2)-th column, in the first direction.

The second-first initialization horizontal voltage line HVAL(R) may pass through the first pixel circuit PC1, the second pixel circuit PC2, and the third pixel circuit PC3 arranged in the i-th row while being electrically connected to the second-first initialization vertical voltage line VVAL(R) passing through the separated space IVA between the second pixel circuit PC2 and the third pixel circuit PC3 arranged in the (j+2)-th column.

The second-first initialization horizontal voltage line HVAL(R) may include a bridge portion HVAL(R)-B extending towards the (i+1)-th row in the first direction (e.g., the ±y-axis direction). The bridge portion HVAL(R)-B may be integrally formed by using the same material as the second-first initialization horizontal voltage line HVAL(R). The bridge portion HVAL(R)-B may be located in the separated space IVA between the second pixel circuit PC2 and the third pixel circuit PC3 arranged in the (i+1)-th row and the (j+2)-th column.

The second-first initialization vertical voltage line VVAL(R) may be electrically connected to the bridge portion HVAL(R)-B of the second-first initialization horizontal voltage line HVAL(R). For example, the second-first initialization vertical voltage line VVAL(R) and the bridge portion HVAL(R)-B of the second-first initialization horizontal voltage line HVAL(R) may be electrically connected to each other through a first connection conductive pattern 1680a overlapping a portion of the bridge portion HVAL(R)-B of the second-first initialization horizontal voltage line HVAL(R) and a portion of the second-first initialization vertical voltage line VVAL(R), in the separated space IVA. For example, the second-first initialization vertical voltage line VVAL(R) may be connected to the first connection conductive pattern 1680a through a contact hole CNT-VA1a and the first connection conductive pattern 1680a may be connected to the bridge portion HVAL(R)-B through a contact hole CNT-VA2a.

The second-second initialization horizontal voltage line HVAL(GB) may pass through the first pixel circuit PC1, the second pixel circuit PC2, and the third pixel circuit PC3 arranged in the i-th row while being electrically connected to the second-second initialization vertical voltage line VVAL(GB) passing through the separated space IVA between the second pixel circuit PC2 and the third pixel circuit PC3 arranged in the (j+3)-th column.

The second-second initialization horizontal voltage line HVAL(GB) may include a bridge portion HVAL(GB)-B extending towards the (i+1)-th row in the first direction (e.g., the ±y-axis direction). The bridge portion HVAL(GB)-B may be integrally formed by using the same material as the second-second initialization horizontal voltage line HVAL(GB). The bridge portion HVAL(GB)-B may be located in the separated space IVA between the second pixel circuit PC2 and the third pixel circuit PC3 arranged in the (i+1)-th row and the (j+3)-th column.

The second-second initialization vertical voltage line VVAL(GB) may be electrically connected to the bridge portion HVAL(GB)-B of the second-second initialization horizontal voltage line HVAL(GB). For example, second-second initialization vertical voltage line VVAL(GB) and the bridge portion HVAL(GB)-B of the second-second initialization horizontal voltage line HVAL(GB) may be electrically connected to each other through a second connection conductive pattern 1680b overlapping a portion of the bridge portion HVAL(GB)-B of the second-second initialization horizontal voltage line HVAL(GB) and a portion of the second-second initialization vertical voltage line VVAL(GB), in the separated space IVA. For example, the second-second initialization vertical voltage line VVAL(GB) may be connected to the second connection conductive pattern 1680b through a contact hole CNT-VA1b and the second connection conductive pattern 1680b may be connected to the bridge portion HVAL(GB)-B through a contact hole CNT-VA2b.

The first data line DL1 , the second data line DL2, and the third data line DL3 arranged in the (j+2)-th column may be electrically connected to the third connection electrode 1650 (or a data connection pattern) respectively through data contact holes DCNT1a, DCNT2a, and DCNT3a. The first data line DL1, the second data line DL2, and the third data line DL3 arranged in the (j+3)-th column may be electrically connected to the third connection electrode 1650 (or the data connection pattern) respectively through data contact holes DCNT1b, DCNT2b, and DCNT3b.

As shown in a region B, in a plan view, the data contact holes DCNT1a, DCNT2a, and DCNT3a located in the (j+2)-th column and the data contact holes DCNT1b, DCNT2b, and DCNT3b located in the (j+3)-th column may be arranged in a row in the second direction (e.g., the ±x-axis direction). The contact hole CNT-VA1a electrically connecting the second-first initialization vertical voltage line VVAL(R) to the first connection conductive pattern 1680a, and the contact hole CNT-VA1belectrically connecting the second-second initialization vertical voltage line VVAL(GB) to the second connection conductive pattern 1680b may be arranged in a row in the second direction (e.g., the ±x-axis direction). Also, in a plan view, the data contact holes DCNT1a, DCNT2a, and DCNT3a located in the (j+2)-th column, and the contact hole CNT-VA1a electrically connecting the second-first initialization vertical voltage line VVAL(R) to the first connection conductive pattern 1680a may be arranged in a row in the second direction (e.g., the ±x-axis direction). Also, in a plan view, the data contact holes DCNT1b, DCNT2b, and DCNT3b located in the (j+3)-th column and the contact hole CNT-VA1b electrically connecting the second-second initialization vertical voltage line VVAL(GB), and the second connection conductive pattern 1680b to each other may be arranged in a row in the second direction (e.g., the ±x-axis direction).

FIG. 21 illustrates the second-first initialization vertical voltage line VVAL(R) and the second-second initialization vertical voltage line VVAL(GB) being arranged in two adjacent columns, but this is only an example, and types of vertical voltage lines in two adjacent columns may be changed.

A contact hole electrically connecting a conductive line arranged on a layer adjacent to a pixel electrode of a light-emitting diode in a direction facing a top surface of a substrate to a conductive pattern disposed below the conductive line may not overlap an emission area of the light-emitting diode. Accordingly, a via insulating layer defining the contact hole provides a substantially flat top surface in a region where the emission area overlaps, and thus, the pixel electrode of the light-emitting diode may be formed substantially flat. Accordingly, a display device may have reduced color deviation or image quality deviation according to a viewing angle. The effects described above are only examples and the effects of the disclosure are not limited to those described above.

In concluding the detailed description, those skilled in the art will appreciate that many variations and modifications may be made to the embodiments without substantially departing from the scope of the invention as defined by the claims. Therefore, the disclosed embodiments are used in a generic and descriptive sense only and not for purposes of limitation.

## Claims

1. A display device comprising:
a plurality of pixels including a first pixel, a second pixel adjacent to the first pixel in a first direction, a third pixel adjacent to the first pixel in a second direction perpendicular to the first direction, and a fourth pixel adjacent to the third pixel in the first direction and adjacent to the second pixel in the second direction, each of the first pixel, the second pixel, the third pixel, and the fourth pixel including a first sub-pixel, a second sub-pixel, and a third sub-pixel, which emit light of different colors;
a first data line extending in the first direction and transmitting a data voltage to the second sub-pixel of the first pixel and the second sub-pixel of the second pixel;
a second data line extending in the first direction and transmitting a data voltage to the second sub-pixel of the third pixel and the second sub-pixel of the fourth pixel;
a first data connection pattern electrically connected to the first data line by a first contact hole and electrically connected to the second sub-pixel of the second pixel; and
a second data connection pattern electrically connected to the second data line by a second contact hole and electrically connected to the second sub-pixel of the fourth pixel, wherein
a distance between an emission area of the third sub-pixel of the first pixel and an emission area of the third sub-pixel of the second pixel is less than a distance between an emission area of the third sub-pixel of the third pixel and an emission area of the third sub-pixel of the fourth pixel in a plan view,
the first contact hole is disposed between the emission area of the third sub-pixel of the first pixel and the emission area of the third sub-pixel of the second pixel in a plan view, and
the first contact hole and the second contact hole are disposed in a row in the second direction in a plan view.

2. The display device of claim 1, wherein, in a plan view, the first contact hole is spaced apart from the emission area of the third sub-pixel of the first pixel and the emission area of the third sub-pixel of the second pixel.

3. The display device of claim 1 or 2, wherein, in a plan view, the second contact hole is disposed between the emission area of the third sub-pixel of the third pixel and the emission area of the third sub-pixel of the fourth pixel.

4. The display device of claim 1, 2 or 3, further comprising:
a third data line extending in the first direction and transmitting a data voltage to the first sub-pixel of the first pixel and the first sub-pixel of the second pixel; and
a third data connection pattern electrically connected to the third data line by a third contact hole and electrically connected to the first sub-pixel of the second pixel,
wherein, in a plan view, the first contact hole, the second contact hole, and the third contact hole are disposed in a row in the second direction.

5. The display device of claim 4, further comprising:
a fourth data line extending in the first direction and transmitting a data voltage to the third sub-pixel of the first pixel and the third sub-pixel of the second pixel; and
a fourth data connection pattern electrically connected to the fourth data line by a fourth contact hole and electrically connected to the third sub-pixel of the second pixel,
wherein, in a plan view, the first contact hole, the second contact hole, the third contact hole, and the fourth contact hole are disposed in a row in the second direction.

6. The display device of any one of the preceding claims, further comprising:
a first vertical voltage line extending in the first direction and transmitting a first voltage that is a constant voltage to each of the first pixel, the second pixel, the third pixel, and the fourth pixel; and
a first voltage connection pattern electrically connected to the first vertical voltage line by a fifth contact hole,
wherein, in a plan view, the first contact hole, the second contact hole, and the fifth contact hole are disposed in a row in the second direction.

7. The display device of claim 6, further comprising:
a second vertical voltage line extending in the first direction and transmitting a second voltage that is a constant voltage to each of the first pixel, the second pixel, the third pixel, and the fourth pixel; and
a second voltage connection pattern electrically connected to the second vertical voltage line by a sixth contact hole,
wherein, in a plan view, the first contact hole, the second contact hole, the fifth contact hole, and the sixth contact hole are disposed in a row in the second direction.

8. The display device of claim 7, wherein
the fifth contact hole is disposed between the emission area of the third sub-pixel of the first pixel and the emission area of the third sub-pixel of the second pixel in a plan view, and
the sixth contact hole is disposed between the emission area of the third sub-pixel of the third pixel and the emission area of the third sub-pixel of the fourth pixel in a plan view.

9. The display device of claim 7 or 8, wherein the first data line, the second data line, the first vertical voltage line, and the second vertical voltage line are disposed on the same layer.

10. The display device of claim 7, 8 or 9, wherein the first data connection pattern, the second data connection pattern, the first voltage connection pattern, and the second voltage connection pattern are disposed on the same layer.

11. The display device of any one of claims 7 to 10, further comprising:
a first horizontal voltage line extending in the second direction and electrically connected to the first voltage connection pattern.

12. The display device of claim 11, further comprising:
a second horizontal voltage line disposed on a different layer from the first horizontal voltage line, extending in the second direction, and electrically connected to the second voltage connection pattern.

13. The display device of any one of the preceding claims, further comprising:
a plurality of separators,
wherein, in a plan view, a separator from among the plurality of separators surrounds the emission area of the third sub-pixel of the first pixel and the emission area of the third sub-pixel of the second pixel.

14. The display device of any one of the preceding claims, wherein the third sub-pixel emits blue light.

15. An electronic device comprising:
a plurality of pixels including a first pixel, a second pixel adjacent to the first pixel in a first direction, a third pixel adjacent to the first pixel in a second direction perpendicular to the first direction, and a fourth pixel adjacent to the third pixel in the first direction and adjacent to the second pixel in the second direction, each of the first pixel, the second pixel, the third pixel, and the fourth pixel including a first sub-pixel, a second sub-pixel, and a third sub-pixel, which emit light of different colors;
a first data line extending in the first direction and transmitting a data voltage to the second sub-pixel of the first pixel and the second sub-pixel of the second pixel;
a second data line extending in the first direction and transmitting a data voltage to the second sub-pixel of the third pixel and the second sub-pixel of the fourth pixel;
a first data connection pattern electrically connected to the first data line by a first contact hole and electrically connected to the second sub-pixel of the second pixel; and
a second data connection pattern electrically connected to the second data line by a second contact hole and electrically connected to the second sub-pixel of the fourth pixel, wherein
a distance between an emission area of the third sub-pixel of the first pixel and an emission area of the third sub-pixel of the second pixel is less than a distance between an emission area of the third sub-pixel of the third pixel and an emission area of the third sub-pixel of the fourth pixel in a plan view,
the first contact hole is disposed between the emission area of the third sub-pixel of the first pixel and the emission area of the third sub-pixel of the second pixel in a plan view, and
the first contact hole and the second contact hole are disposed in a row in the second direction in a plan view.
